# EUROPEAN PATENT APPLICATION

(11) **EP 1 607 751 A1**
(43) Date of publication of application: **21.12.2005**
(21) Application number: 04722682.4
(22) Date of filing: 23.03.2004
(51) Int. Cl.: G01R 1/073

(54) **CONNECTOR FOR MEASUREMENT OF ELECTRIC RESISTANCE, CONNECTOR DEVICE FOR MEASUREMENT OF ELECTRIC RESISTANCE AND PRODUCTION PROCESS THEREOF, AND MEASURING APPARATUS AND MEASURING METHOD OF ELECTRIC RESISTANCE FOR CIRCUIT BOARD**

(30) Priority: 26.03.2003 JP 2003085173
(71) Applicant: JSR Corporation, Tokyo 104-0045 (JP)
(72) Inventor: KIMURA, Kiyoshi, Hidaka-shi, Saitama 3501236 (JP); SHIMODA, Sugiro, Hidaka-shi, Saitama 3501236 (JP); HARA, Fujio, Hidaka-shi, Saitama 3501236 (JP)
(74) Representative: TBK-Patent
(86) International application number: PCT/JP2004/003936
(87) International publication number: WO 2004/086062

(57) **Abstract**

Disclosed herein are a connector for measurement of electric resistance and a connector device for measurement of electric resistance, by which necessary electrical connection can be surely achieved even when a circuit board to be inspected is large in area and has a great number of small-sized electrodes to be inspected, and expected measurement of electric resistance can be surely performed with high precision, a production process of the connector device for measurement of electric resistance, and a measuring apparatus and a measuring method of electric resistance for circuit boards.

The connector for measurement of electric resistance according to the present invention comprises an insulating substrate and plural sets of connecting electrodes arranged on a front surface of the insulating substrate in accordance with a pattern corresponding to a pattern of a plurality of electrodes to be inspected in a circuit board to be inspected, the electric resistance of which should be measured. Each of the sets of connecting electrodes is composed of at least 3 electrodes of electrode(s) for current supply and electrode(s) for voltage measurement arranged in a state separated from one another, at least one of these electrodes is an electrode for current supply, and at least one thereof is an electrode for voltage measurement.

## Description

### TECHNICAL FIELD

The present invention relates to a connector for measurement of electric resistance, a connector device for measurement of electric resistance and a production process thereof, and a measuring apparatus and a measuring method of electric resistance for circuit boards.

### BACKGROUND ART

In recent years, with the request for speeding-up of signal transmission in electronic parts and electronic equipments containing such a part therein, there has been a demand for development of those low in electric resistance of wiring between electrodes as circuit boards for fabricating LSI packages such as BGA and CSP or circuit boards, on which these semiconductor devices are mounted. Therefore, it is extremely important to measure the electric resistance of wiring between electrodes of such a circuit board with high precision in electrical inspection of the circuit board.

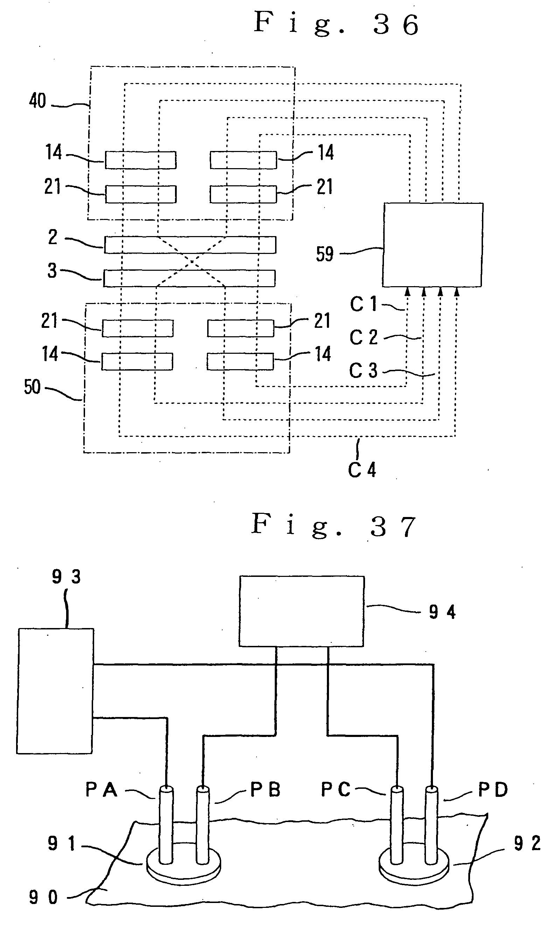

In the measurement of an electric resistance of a circuit board, there has heretofore been adopted, for example, the four probe method, in which probes PA and PD for current supply and probes PB and PC for voltage measurement are pressed against and brought into respective contact with 2 electrodes 91 and 92 to be inspected, which have been electrically connected to each other in a circuit board 90 to be inspected, as illustrated in Fig. 37, a current is supplied between the proves PA and PD for current supply from a power supply device 93 in this state, and a voltage signal detected by the probes PB and PC for voltage measurement at this time is processed in an electric signal processor 94, thereby finding an electric resistance value between the electrodes 91 and 92 to be inspected.

In the method described above, however, the surfaces of the electrodes 91 and 92 to be inspected may be damaged by pressing the probes PA and PD for current supply and the probes PB and PC for voltage measurement against them because it is necessary to bring the probes into respective contact with the electrodes 91 and 92 to be inspected by considerably high pressing force, the probes are made of a metal, and the tips thereof are pointed. It is therefore impossible to use the circuit board. Under such circumstances, the measurement of the electric resistance cannot be performed on all circuit boards to be provided as products, and so the method cannot help adopting the so-called sampling inspection. After all, the yield of the products cannot be increased.

In order to solve such a problem, there have heretofore been proposed electric resistance-measuring apparatus, in which a connecting member coming into contact with electrodes to be inspected is made up of a conductive elastomer. Specifically, (i) an electric resistance-measuring apparatus, in which elastic connecting members formed of conductive rubber obtained by binding conductive particles with an elastomer are arranged at electrodes for current supply and electrodes for voltage measurement, respectively (see the following Prior Art. 1), (ii) an electric resistance-measuring apparatus having a common elastic connecting member provided so as to come into contact with surfaces of both electrode for current supply and electrode for voltage measurement electrically connected to the same electrode to be inspected and formed of an anisotropically conductive elastomer (see the following Prior Art. 2), (iii) an electric resistance-measuring apparatus comprising a circuit board for inspection, on the surface of which a plurality of inspection electrodes have been formed, and an elastic connecting member provided on the surface of the circuit board for inspection and formed of a conductive elastomer, wherein 2 electrodes of the inspection electrodes are selected in a state that electrodes to be inspected have been electrically connected to the plurality of the inspection electrodes through the connecting member, one of both electrodes is used as an electrode for current supply, and the other is used as an electrode for voltage measurement to measure an electric resistance (see the following Prior Art. 3), and the like are known.

According to such electric resistance-measuring apparatus, electrodes for current supply and electrodes for voltage measurement are brought into contact with electrodes to be inspected of a circuit board to be inspected through the elastic connecting member, whereby electrical connection is achieved, so that the measurement of the electric resistance can be conducted without damaging the electrodes to be inspected.

However, the measurement of an electric resistance between electrodes by the electric resistance-measuring apparatus of the constructions (i) and (ii) involve the following problems.

In recent years, the size and pitch or interelectrode distance of electrodes in a circuit board have tended to become small for the purpose of achieving a high degree of integration. In the electric resistance-measuring apparatus of the constructions (i) and (ii), however; it is necessary to electrically connect both electrodes for current supply and electrodes for voltage measurement at the same time to electrodes to be inspected in a circuit board to be inspected, the electric resistance of which should be measured, through the elastic connecting member, respectively. In the electric resistance-measurement apparatus for measuring an electric resistance as to a circuit board to be inspected, on which small-sized electrodes to be inspected have been arranged at a high density, it is thus necessary to form an electrode for current supply and an electrode for voltage measurement corresponding to each of the small-sized electrodes to be inspected in a state separated from one another in a region of an area equal to or smaller than a region occupied by the electrode to be inspected, i.e., to form an electrode for current supply and an electrode for voltage measurement, which are smaller in size than the electrode to be inspected, in a state separated from each other at an extremely short distance.

On the other hand, in order to improve productivity, it is adopted as a production process of circuit boards to produce a combined circuit board composed of a plurality of circuit boards linked with each other by a board material, collectively conduct electrical inspection as to the respective circuit boards in the combined circuit board in this state and then cut the combined circuit board, thereby producing a plurality of circuit board separated from each other.

However, the area of the combined circuit board, which is an object of inspection, is considerably large, and number of electrodes to be inspected is also extremely great. When multi-layer circuit boards are produced in particular, the number of steps in the production process thereof is great, and the number of times subjected to thermal hysteresis by heating treatment is great, so that electrodes to be inspected are often formed in a state misregistered from the prescribed arrangement positions. When measurement of an electric resistance is performed as to the circuit board to be inspected, which is large in area and has a great number of electrodes to be inspected formed in a state misregistered from the prescribed arrangement positions as described above, by the electric resistance-measuring apparatus of the constructions (i) and (ii), it is extremely difficult to electrically connect both electrode for current supply and electrode for voltage measurement at the same time to each of the electrodes to be inspected.

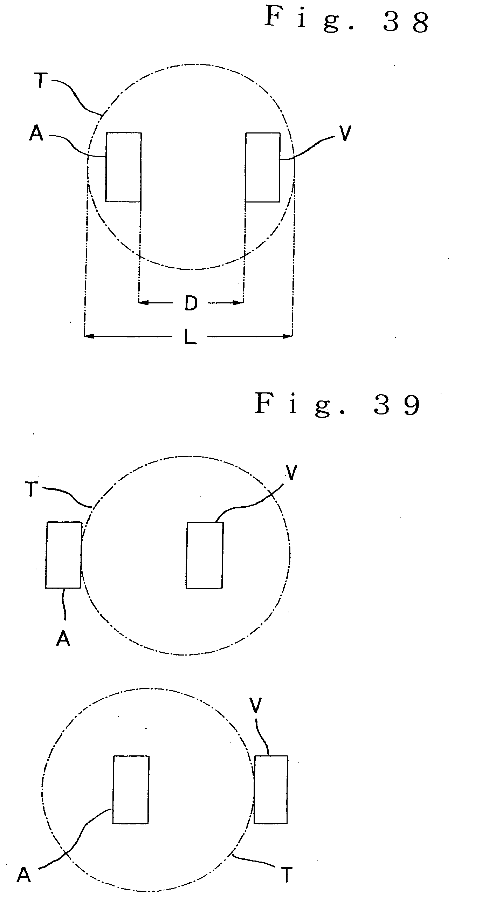

Description is given by a specific example. When an electric resistance as to an electrode T to be inspected having a diameter L of 300 µm is measured as shown in Fig. 38, a clearance D between an electrode A for current supply and an electrode V for voltage measurement to be electrically connected to the electrode T to be inspected is about 150 µm. When the position of the electrode T to be inspected to the electrode A for current supply and the electrode V for voltage measurement deviates from the prescribed position shown in Fig. 38 by 75 µm in a direction (lateral direction in the drawing) that the electrode A for current supply and the electrode V for voltage measurement are arranged, in alignment of a circuit board to be inspected as shown in Figs. 39(a) and 39(b), electrical connection between either one of the electrode A for current supply and the electrode V for voltage measurement and the electrode T to be inspected is not achieved, and so necessary measurement of the electric resistance cannot be conducted.

On the other hand, according to the electric resistance-measuring apparatus (iii), there is no need to form an electrode for current supply and an electrode for voltage measurement corresponding to each of electrodes to be inspected, and so tolerance for misregistration to electrodes to be inspected becomes high even when a circuit board to be inspected, the electric resistance of which should be measured, is large in area and has a great number of electrodes to be inspected, and the electrodes to be inspected are small in size and arranged at a high density. In addition, such an electric resistance-measuring apparatus is easily produced.

Since such an electric resistance-measuring apparatus is a measuring apparatus according to the so-called pseudo-four-probe method, however, a measurement error range is great, and it is thus difficult to perform measurement of an electric resistance as to a circuit board low in electric resistance between electrodes with high precision.
Prior Art. 1: Japanese Patent Application Laid-Open No. 26446/1997;
Prior Art. 2: Japanese Patent Application Laid-Open No. 2000-74965;
Prior Art. 3: Japanese Patent Application Laid-Open No. 2000-241485.

### DISCLOSURE OF THE INVENTION

The present invention has been made on the basis of the foregoing circumstances and has as its first object the provision of a connector for measurement of electric resistance, by which necessary electrical connection to a circuit board to be inspected, the electric resistance of which should be measured, can be surely achieved even when the circuit board to be inspected is large in area and has a great number of small-sized electrodes to be inspected, and expected measurement of electric resistance can be surely performed with high precision.

A second object of the present invention is to provide a connector device for measurement of electric resistance, by which necessary electrical connection to a circuit board to be inspected, the electric resistance of which should be measured, can be surely achieved even when the circuit board to be inspected is large in area and has a great number of small-sized electrodes to be inspected, expected measurement of electric resistance can be surely performed with high precision, and moreover good electrical connection is stably retained even on an environmental change such as thermal hysteresis by temperature change.

A third object of the present invention is to provide a process for advantageously producing the above-described connector device for measurement of electric resistance.

A fourth object of the present invention is to provide an electric resistance-measuring apparatus for circuit boards, by which necessary electrical connection to a circuit board to be inspected, the electric resistance of which should be measured, can be surely achieved even when the circuit board to be inspected is large in area and has a great number of small-sized electrodes to be inspected, and expected measurement of electric resistance can be surely performed with high precision.

A fifth object of the present invention is to provide an electric resistance-measuring method for circuit boards, by which necessary electrical connection to a circuit board to be inspected, the electric resistance of which should be measured, can be surely achieved even when the circuit board to be inspected is large in area and has a great number of small-sized electrodes to be inspected, and expected measurement of electric resistance can be surely performed with high precision.

According to the present invention, there is provided a connector for measurement of electric resistance, comprising an insulating substrate and plural sets of connecting electrodes arranged on a front surface of the insulating substrate in accordance with a pattern corresponding to a pattern of a plurality of electrodes to be inspected in a circuit board to be inspected, the electric resistance of which should be measured,
wherein each of the sets of connecting electrodes is composed of at least 3 electrodes of electrode(s) for current supply and electrode(s) for voltage measurement arranged in a state separated from one another, at least one of these electrodes is an electrode for current supply, and at least one thereof is an electrode for voltage measurement.

According to the present invention, there is also provided a connector for measurement of electric resistance, comprising an insulating substrate and plural sets of connecting electrodes arranged on a front surface of the insulating substrate in accordance with a pattern corresponding to a pattern of a plurality of electrodes to be inspected in a circuit board to be inspected, the electric resistance of which should be measured,
wherein each of the sets of connecting electrodes is composed of 2 electrodes for current supply, which are located at vertical positions of angles opposite to each other in a rectangle, and 2 electrodes for voltage measurement, which are located at the other vertical positions of angles opposite to each other, said electrodes being arranged in a state separated from one another.

According to the present invention, there is further provided a connector for measurement of electric resistance, comprising an insulating substrate and plural sets of connecting electrodes arranged on a front surface of the insulating substrate in accordance with a pattern corresponding to a pattern of a plurality of electrodes to be inspected in a circuit board to be inspected, the electric resistance of which should be measured,
wherein each of the sets of connecting electrodes is composed of 3 electrodes of an electrode for voltage measurement, an electrode for current supply and an electrode for voltage measurement, which are arranged in a state separated from one another so as to align in this order.

According to the present invention, there is still further provided a connector for measurement of electric resistance, comprising an insulating substrate and plural sets of connecting electrodes arranged on a front surface of the insulating substrate in accordance with a pattern corresponding to a pattern of a plurality of electrodes to be inspected in a circuit board to be inspected, the electric resistance of which should be measured,
wherein each of the sets of connecting electrodes is composed of 3 electrodes of an electrode for current supply, an electrode for voltage measurement and an electrode for current supply, which are arranged in a state separated from one another so as to align in this order.

In the connectors for measurement of electric resistance having the sets of connecting electrodes each composed of the 3 electrodes arranged in the above-described manner, each of the electrodes for current supply and the electrodes for voltage measurement in the set of connecting electrode may preferably have a form long in a direction perpendicular to the arrangement direction of these electrodes.

In the connectors for measurement of electric resistance according to the present invention, a plurality of relay electrodes electrically connected to any ones of the electrodes for current supply and electrodes for voltage measurement may preferably be arranged on a back surface of the insulating substrate.

Such connectors for measurement of electric resistance may preferably have the relay electrodes electrically connected to a plurality of the electrodes for current supply.

According to the present invention, there is provided a connector device for measurement of electric resistance, comprising the connector for measurement of electric resistance according to any one of the above-described constructions, and an anisotropically conductive elastomer layer integrally laminated on a front surface of the connector for measurement of electric resistance.

In the connector device for measurement of electric resistance, the anisotropically conductive elastomer layer may preferably be composed of a plurality of conductive path-forming parts arranged on the respective surfaces of the electrodes for current supply and the electrodes for voltage measurement and each extending in a thickness-wise direction thereof, and an insulating part mutually insulating these conductive path-forming parts.

The conductive path-forming parts may preferably contain conductive particles exhibiting magnetism in a state oriented so as to align in the thickness-wise direction.

According to the present invention, there is provided a process for producing the connector device for measurement of electric resistance according to the above-described construction, which comprises the steps of
forming, on a front surface of the connector for measurement of electric resistance, an elastomer layer containing conductive particles exhibiting magnetism in portions located on the surfaces of the regions, in which the sets of connecting electrodes of the connector for measurement of electric resistance have been formed, in a state oriented so as to align in a thickness-wise direction thereof by forming, on the front surface of the connector for measurement of electric resistance, a material layer for elastomer with the conductive particles exhibiting magnetism contained in a liquid polymeric substance-forming material, which will become an elastic polymeric substance by being cured, applying a magnetic field having higher intensity at portions located on the surfaces of the regions, in which the sets of connecting electrodes have been formed, than the other portions, to the material layer for elastomer in a thickness-wise direction thereof and subjecting the material layer for elastomer to a curing treatment,
removing portions located on the surfaces of regions between the respective electrodes of the sets of connecting electrodes in the portions containing the conductive particles in this elastomer layer to form hole portions, and then
filling a liquid polymeric substance-forming material, which will become an elastic polymeric substance by being cured, into the hole portions and subjecting the polymeric substance-forming material to a curing treatment.

According to the present invention, there is provided an electric resistance-measuring apparatus for circuit boards for measuring an electric resistance of a circuit board having electrodes on at least one surface thereof, which comprises
the connector for measurement of electric resistance according to any one of the above-described constructions, which is arranged on one surface side of a circuit board to be inspected, the electric resistance of which should be measured.

According to the present invention, there is also provided an electric resistance-measuring apparatus for circuit boards for measuring an electric resistance of a circuit board having electrodes on at least one surface thereof, which comprises
the connector for measurement of electric resistance having the relay electrodes on the back surface thereof, which is arranged on one surface side of a circuit board to be inspected, the electric resistance of which should be measured, and
a one surface-side circuit board for inspection arranged on a back surface of this connector for measurement of electric resistance through an anisotropically conductive sheet and having, on its surface, inspection electrodes arranged in accordance with a pattern corresponding to a pattern of the relay electrodes of the connector for measurement of electric resistance.

When the circuit board to be inspected, the electric resistance of which should be measured, has electrodes on both surfaces thereof, the electric resistance-measuring apparatus for circuit boards may be such that further comprises an other surface-side circuit board for inspection arranged on the other surface side of the circuit board to be inspected, the electric resistance of which should be measured,
wherein the other surface-side circuit board for inspection has, on its front surface, an electrode for current supply and an electrode for voltage measurement, which are arranged corresponding to each of the other surface-side electrodes to be inspected of the circuit board to be inspected and in a state separated from each other, and formed electrically connected to the same other surface-side electrode to be inspected.

According to the present invention, there is further provided an electric resistance-measuring apparatus for circuit boards for measuring an electric resistance of a circuit board having electrodes on both surfaces thereof, which comprises
the connector for measurement of electric resistance according to any one of the above-described constructions, which is arranged on one surface side of a circuit board to be inspected, the electric resistance of which should be measured, and
the connector for measurement of electric resistance according to any one of the above-described constructions, which is arranged on the other surface side of the circuit board to be inspected.

According to the present invention, there is still further provided an electric resistance-measuring apparatus for circuit boards for measuring an electric resistance of a circuit board having electrodes on both surfaces thereof, which comprises
the connector for measurement of electric resistance according to any one of the above-described constructions, which is arranged on one surface side of a circuit board to be inspected, the electric resistance of which should be measured,
a one surface-side circuit board for inspection arranged on a back surface of this connector for measurement of electric resistance through an anisotropically conductive sheet and having, on its surface, inspection electrodes arranged in accordance with a pattern corresponding to a pattern of the relay electrodes of the connector for measurement of electric resistance,
the connector for measurement of electric resistance according to any one of the above-described constructions, which is arranged on the other surface side of the circuit board to be inspected, and
an other surface-side circuit board for inspection arranged on a back surface of this connector for measurement of electric resistance through an anisotropically conductive sheet and having, on its surface, inspection electrodes arranged in accordance with a pattern corresponding to a pattern of the relay electrodes of the connector for measurement of electric resistance.

According to the present invention, there is provided an electric resistance-measuring method for circuit boards, which comprises arranging any one of the above-described connectors for measurement of electric resistance on one surface of a circuit board to be inspected, the electric resistance of which should be measured,
electrically connecting at least one electrode for current supply and at least one electrode for voltage measurement in the set of connecting electrodes of the connector for measurement of electric resistance at the same time to each of one surface-side electrodes to be inspected of the circuit board to be inspected, thereby bringing about a measurable state, and
in this measurable state, supplying a current to the circuit board to be inspected through the electrode for current supply in the connector for measurement of electric resistance and designating one electrode for voltage measurement among the electrodes for voltage measurement electrically connected to the one surface-side electrodes to be inspected to perform measurement of an electric resistance as to the one surface-side electrode to be inspected electrically connected to the designated one electrode for voltage measurement.

### EFFECTS OF THE INVENTION

According to the connectors for measurement of electric resistance of the present invention, the sets of connecting electrodes arranged in accordance with a pattern corresponding to a pattern of electrodes to be inspected in a circuit board to be inspected each have at least 2 electrodes for current supply and/or electrodes for voltage measurement, so that tolerance for misregistration of the electrodes to be inspected becomes high by arranging these electrodes in a proper positional relation.

For example, 2 electrodes for current supply in each of the sets of connecting electrodes are located at vertical positions of angles opposite to each other in a rectangle, and 2 electrodes for voltage measurement are located at the other vertical positions of angles opposite to each other in the rectangle, whereby an electrode to be inspected is electrically connected to both of at least one electrode for current supply and at least one electrode for voltage measurement at the same time even when the electrode to be inspected is misregistered in a direction of a side of the rectangle.

In the set of connecting electrodes, 3 electrodes of the electrode for voltage measurement, electrode for current supply and electrode for voltage measurement are arranged so as to align in this order, or 3 electrodes of the electrode for current supply, electrode for voltage measurement and electrode for current supply are arranged so as to align in this order, whereby an electrode to be inspected is electrically connected to both of at least one electrode for current supply and at least one electrode for voltage measurement at the same time even when the electrode to be inspected is misregistered in the arrangement direction of these electrodes. In addition, in such construction, each of the electrodes for current supply and the electrodes for voltage measurement has a form long in a direction perpendicular to the arrangement direction of these electrodes, whereby an electrode to be inspected is electrically connected to both electrode for current supply and electrode for voltage measurement at the same time even when the electrode to be inspected is misregistered in the direction perpendicular to the arrangement direction of the respective electrodes in the set of connecting electrodes.

According to the connectors for measurement of electric resistance of the present invention, thus, necessary electrical connection to a circuit board to be inspected, the electric resistance of which should be measured, can be surely achieved even when the circuit board to be inspected is large in area and has a great number of small-sized electrodes to be inspected, and expected measurement of electric resistance can be surely performed with high precision.

According to the connector devices for measurement of electric resistance of the present invention, any one of the above-described connectors for measurement of electric resistance is provided, so that necessary electrical connection to a circuit board to be inspected, the electric resistance of which should be measured, can be surely achieved even when the circuit board to be inspected is large in area and has a great number of small-sized electrodes to be inspected, expected measurement of electric resistance can be surely performed with high precision, and moreover good electrical connection can be stably retained even on an environmental change such as thermal hysteresis by temperature change.

According to the production process of a connector device for measurement of electric resistance of the present invention, the above-described connector devices for measurement of electric resistance can be advantageously produced.

According to the electric resistance-measuring apparatus for circuit board of the present invention, any one of the above-described connectors for measurement of electric resistance is provided, so that necessary electrical connection to a circuit board to be inspected, the electric resistance of which should be measured, can be surely achieved even when the circuit board to be inspected is large in area and has a great number of small-sized electrodes to be inspected, and expected measurement of electric resistance can be surely performed with high precision.

According to the electric resistance-measuring method for circuit board of the present invention, any one of the above-described connectors for measurement of electric resistance is used, so that necessary electrical connection to a circuit board to be inspected, the electric resistance of which should be measured, can be surely achieved even when the circuit board to be inspected is large in area and has a great number of small-sized electrodes to be inspected, and expected measurement of electric resistance can be surely performed with high precision.

### BRIEF DESCRIPTION OF THE DRAWINGS

Fig. 1 is a plan view illustrating a connector for measurement of electric resistance according to a first embodiment of the present invention.
Fig. 2 is a cross-sectional view illustrating the construction of the connector for measurement of electric resistance according to the first embodiment.
Fig. 3 is a cross-sectional view illustrating a state that the connector for measurement of electric resistance shown in Fig. 1 has been arranged on one surface of a circuit board to be inspected though an anisotropically conductive sheet.
Fig. 4 illustrates a state that misregistration has occurred between a set of connecting electrodes in the connector for measurement of electric resistance according to the first embodiment and an electrode to be inspected.
Fig. 5 is a cross-sectional view illustrating the construction of a circuit board to be inspected.
Fig. 6 is a plan view illustrating a connector for measurement of electric resistance according to a second embodiment of the present invention.
Fig. 7 is a cross-sectional view illustrating the construction of the connector for measurement of electric resistance according to the second embodiment.
Fig. 8 illustrates a state that misregistration has occurred between a set of connecting electrodes in the connector for measurement of electric resistance according to the second embodiment and an electrode to be inspected.
Fig. 9 is a plan view illustrating a connector for measurement of electric resistance according to a third embodiment of the present invention.
Fig. 10 is a cross-sectional view illustrating the construction of the connector for measurement of electric resistance according to the third embodiment.
Fig. 11 is a cross-sectional view illustrating the construction of a connector for measurement of electric resistance according to a fourth embodiment of the present invention.
Fig. 12 is a cross-sectional view illustrating the construction of a connector device for measurement of electric resistance according to a first embodiment of the present invention.
Fig. 13 is a plan view illustrating the connector device for measurement of electric resistance shown in Fig. 12, the anisotropically conductive elastomer layer thereof being partly broken away.
Fig. 14 is a cross-sectional view illustrating the construction of an exemplary mold for obtaining the anisotropically conductive elastomer layer.
Fig. 15 is a cross-sectional view illustrating a state that a material layer for elastomer has been formed on a front surface of a connector for measurement of electric resistance.
Fig. 16 is a cross-sectional view illustrating a state that a magnetic field having a intensity distribution has been applied in a thickness-wise direction of the material layer for elastomer.
Fig. 17 is a cross-sectional view illustrating a state that an elastomer layer has been formed on a front surface of the connector for measurement of electric resistance.
Fig. 18 is a cross-sectional view illustrating a state that hole portions have been formed in the elastomer layer.
Fig. 19 is a cross-sectional view illustrating a state that a polymeric substance-forming material has been filled into the hole portions formed in the elastomer layer.
Fig. 20 is a cross-sectional view illustrating the construction of a connector device for measurement of electric resistance according to a second embodiment of the present invention.
Fig. 21 is a plan view illustrating the connector device for measurement of electric resistance shown in Fig. 20, the anisotropically conductive elastomer layer thereof being partly broken away.
Fig. 22 is a cross-sectional view illustrating a state that a conductive elastomer layer has been formed on a releasable supporting plate.
Fig. 23 is a cross-sectional view illustrating a state that a metallic thin layer has been formed on the conductive elastomer layer.
Fig. 24 is a cross-sectional view illustrating a state that a resist layer having openings has been formed on the metallic thin layer.
Fig. 25 is a cross-sectional view illustrating a state that metal masks have been formed in the openings of the resist layer.
Fig. 26 is a cross-sectional view illustrating a state that a plurality of conductive path-forming parts have been formed on the releasable supporting plate.
Fig. 27 is a cross-sectional view illustrating a state that a material layer for insulating part has been formed on a front surface of the connector for measurement of electric resistance.
Fig. 28 is a cross-sectional view illustrating a state that the releasable supporting plate, on which the conductive path-forming parts were formed, has been superimposed on the connector for measurement of electric resistance, on which the material layer for insulating part was formed.
Fig. 29 is a cross-sectional view illustrating a state that insulating part has been formed between adjacent conductive path-forming parts.
Fig. 30 is a cross-sectional view illustrating the construction of a connector device for measurement of electric resistance according to a further embodiment of the present invention.
Fig. 31 is a cross-sectional view schematically illustrating the construction of an electric resistance-measuring apparatus for circuit boards according to a first embodiment of the present invention together with a circuit board to be inspected.
Fig. 32 is a cross-sectional view illustrating, on an enlarged scale, a principal part of the electric resistance-measuring apparatus for circuit boards according to the first embodiment.
Fig. 33 typically illustrates a circuit for voltage measurement formed by the electric resistance-measuring apparatus for circuit boards according to the first embodiment.
Fig. 34 is a cross-sectional view schematically illustrating the construction of an electric resistance-measuring apparatus for circuit boards according to a second embodiment of the present invention together with a circuit board to be inspected.
Fig. 35 is a cross-sectional view illustrating, on an enlarged scale, a principal part of the electric resistance-measuring apparatus for circuit boards according to the second embodiment.
Fig. 36 typically illustrates a circuit for voltage measurement formed by the electric resistance-measuring apparatus for circuit boards according to the second embodiment.
Fig. 37 typically illustrates an apparatus for measuring an electric resistance between electrodes in a circuit board by probes for current supply and probes for voltage measurement.
Fig. 38 illustrates a state that an electrode for current supply and an electrode for voltage measurement have been correctly arranged on an electrode to be inspected in a conventional electric resistance-measuring apparatus for circuit boards.
Fig. 39 illustrates a state that an electrode for current supply and an electrode for voltage measurement have been arranged in a state misregistered on an electrode to be inspected in the conventional electric resistance-measuring apparatus for circuit boards.

### [Description of Characters]

- 1: Circuit board to be inspected,
- 2: One surface-side electrodes to be inspected,
- 3: Other surface-side electrodes to be inspected,
- 4a, 4b: Circuits, 5 Anisotropically conductive sheet,
- 10: Connector for measurement of electric resistance,
- 11: Insulating substrate,
- 12: Sets of connecting electrodes,
- 13: Electrodes for current supply,
- 14: Electrodes for voltage measurement,
- 15: Relay electrodes,
- 16: Wiring parts,
- 20: Anisotropically conductive elastomer layer,
- 20A: Material layer for elastomer,
- 20B: Elastomer layer,
- 21: Conductive path-forming parts,
- 21A: Conductive elastomer layer,
- 22: Insulating part,
- 22A: Material layer for insulating part,
- 23: Projected parts,
- 23A: Polymeric substance-forming material
- 25: Connector device for measurement of electric resistance,
- 26: Releasable supporting plate,
- 27: Metallic thin layer 28 Resist layer,
- 28a: Openings 29 Metal masks,
- 30: Top force,
- 31: Ferromagnetic base plate,
- 32: Ferromagnetic substance layer,
- 33: Non-magnetic substance layer,
- 35: Bottom force,
- 36: Ferromagnetic base plate,
- 37: Ferromagnetic substance layer,
- 38: Non-magnetic substance layer,
- 40: Upper-side adaptor,
- 41: One surface-side circuit board for inspection,
- 42: Inspection electrodes, 43 Terminal electrodes,
- 44: First upper-side anisotropically conductive sheet,
- 45: Second upper-side anisotropically conductive sheet,
- 48: Electrode plate,
- 49: Standard arrangement electrodes,
- 50: Lower-side adaptor,
- 51: Other surface-side circuit board for inspection,
- 52: Inspection electrodes, 53 Terminal electrodes,
- 52a: Inspection electrodes for current supply,
- 52b: Inspection electrodes for voltage measurement,
- 53a: Terminal electrodes for current supply,
- 53b: Terminal electrodes for voltage measurement,
- 55: Anisotropically conductive elastomer layer,
- 56: Conductive path-forming parts,
- 57: Insulating part, 59 Tester,
- 60: Electrode plate,
- 61: Standard arrangement electrodes,
- 62: Lower-side anisotropically conductive sheet,
- 64: First lower-side anisotropically conductive sheet,
- 65: Second lower-side anisotropically conductive sheet,
- 90: Circuit board to be inspected,
- 91, 92: Electrodes to be inspected,
- 93: Power supply device,
- 94: Electric signal processor,
- PA, PD: Probes for current supply,
- PB, PC: Probes for voltage measurement,
- A: Electrode for current supply,
- V: Electrode for voltage measurement,
- T: Electrode to be inspected,
- P: Conductive particles,
- K: Hole parts,
- C1, C2, C3, C4: Circuits for voltage measurement.

### BEST MODE FOR CARRYING OUT THE INVENTION

The embodiments of the present invention will hereinafter be described in details.

### <Connector for measurement of electric resistance>

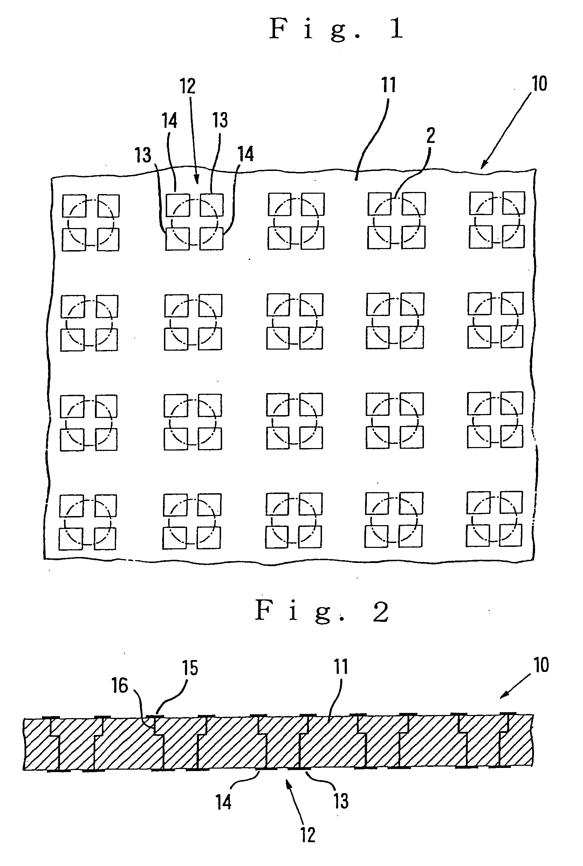

Fig. 1 is a plan view illustrating a connector for measurement of electric resistance according to a first embodiment of the present invention, and Fig. 2 is a cross-sectional view illustrating the construction of the connector for measurement of electric resistance according to the first embodiment.

The connector 10 for measurement of electric resistance according to the first embodiment has an insulating substrate 11. On a front surface of this insulating substrate 11, plural sets 12 of connecting electrodes are arranged in accordance with a pattern corresponding to a pattern of one surface-side electrodes 2 (indicated by an alternate long and short dash line) to be inspected formed on one surface of a circuit board, the electric resistance of which should be measured. These sets 12 of connecting electrodes are each composed of 4 electrodes in total of 2 rectangular electrodes 13 for current supply and 2 rectangular electrodes 14 for voltage measurement as illustrated in Fig. 1. These 4 electrodes are arranged in a state separated from one another in such a manner that the electrodes 13 for current supply are respectively located at vertical positions of angles opposite to each other in a rectangle, and the electrodes 14 for voltage measurement are respectively located at the other vertical positions of angles opposite to each other in the rectangle.

On a back surface of the insulating substrate 11, a plurality of relay electrodes 15 are arranged in accordance with a proper pattern as illustrated in Fig. 2, and either one of the electrode 13 for current supply and the electrode 14 for voltage measurement is electrically connected to each of these relay electrodes 15 through a wiring part 16 formed in the insulating substrate 11.

As a material for forming the insulating substrate 11, may be used a polyimide resin, glass fiber-reinforced polyimide resin, glass fiber-reinforced epoxy resin, glass fiber-reinforced bismaleimide triazine resin or the like. The insulating substrate 11 may be a single-layer structure or multi-layer structure.

The thickness of the insulating substrate 11 is preferably, for example, 50 to 1,000 µm, more preferably 100 to 500 µm.

As a material for forming the electrodes 13 for current supply, electrode 14 for voltage measurement, relay electrodes 15 and wiring parts 16, may be used copper, nickel, gold or a laminate of these metals.

The electrodes 13 for current supply, electrode 14 for voltage measurement, relay electrodes 15 and wiring parts 16 can be formed by a method generally used for producing a printed wiring board.

A clearance between the electrode 13 for current supply and the electrode 14 for voltage measurement in the set 12 of connecting electrodes is preferably 20 to 100 µm, more preferably 30 to 80 µm. If this clearance is too small, it may be difficult in some cases to secure necessary insulating property between the electrode 13 for current supply and the electrode 14 for voltage measurement, and it may also be difficult in some cases to produce the connector 10 for measurement of electric resistance. If this clearance is too large on the other hand, tolerance for misregistration to electrodes to be inspected becomes low, so that it may be difficult in some cases to surely electrically connect both electrode 13 for current supply and electrode 14 for voltage measurement to an electrode to be inspected.

As illustrated in Fig. 3, the above-described connector 10 for measurement of electric resistance is arranged on one surface of a circuit board 1 to be inspected, the electric resistance of which should be measured, through, for example, an anisotropically conductive sheet 5 in such a manner that the respective sets 12 of connecting electrodes in the connector 10 for measurement of electric resistance are located on their corresponding one surface-side electrodes 2 to be inspected of the circuit board 1 to be inspected, and pressed by a proper means, whereby the one surface-side electrodes 2 to be inspected of the circuit board 10 to be inspected are electrically connected to the electrodes of the sets 12 of connecting electrodes in the connector 10 for measurement of electric resistance through the anisotropically conductive sheet 5.

In such a state, a constant current is supplied between the electrodes to be inspected of the circuit board 1 to be inspected through the electrodes 13 for current supply, and one electrode 14 for voltage measurement of the electrodes 14 for voltage measurement electrically connected to the one surface-side electrodes 2 to be inspected in the circuit board 10 to be inspected is designated to conduct measurement of an electric resistance as to the one surface-side electrode 2 to be inspected electrically connected to the designated electrode 14 for voltage measurement. Measurement of electric resistances as to all the one surface-side electrodes 2 to be inspected is conducted by successively changing an electrode 14 for voltage measurement to be designated.

According to the connector 10 for measurement of electric resistance according to the first embodiment, in each of the sets 12 of connecting electrodes, 2 electrodes 13 for current supply are located at vertical positions of angles opposite to each other in a rectangle, and 2 electrodes 14 for voltage measurement are located at the other vertical positions of angles opposite to each other in the rectangle, so that a one surface-side electrode 2 to be inspected is electrically connected to both of at least one electrode 13 for current supply and at least one electrode 14 for voltage measurement at the same time even when the one surface-side electrode 2 to be inspected is misregistered in directions (lateral and vertical directions in Fig. 1) of sides of the rectangle.

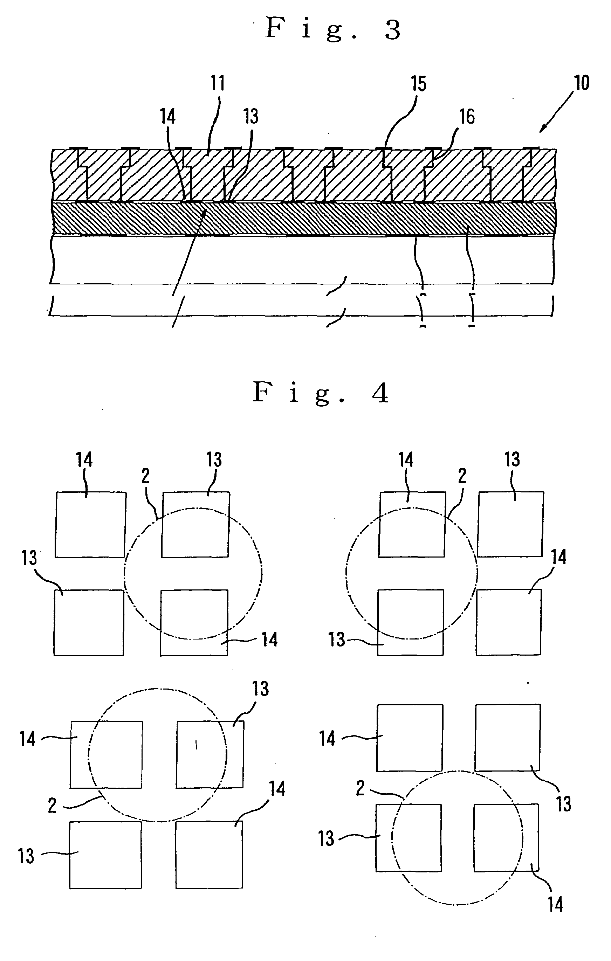

Description is given by a specific example. When the central position of the one surface-side electrode 2 to be inspected is misregistered from the central position of the set 12 of connecting electrodes to the right-hand side in the drawing as illustrated in Fig. 4(a), the one surface-side electrode 2 to be inspected is electrically connected to both electrode for current supply 13 and electrode for voltage measurement 14, which are located on the right-hand side in the drawing, at the same time.

When the central position of the one surface-side electrode 2 to be inspected is misregistered from the central position of the set 12 of connecting electrodes to the left-hand side in the drawing as illustrated in Fig. 4(b), the one surface-side electrode 2 to be inspected is electrically connected to both electrode for current supply 13 and electrode for voltage measurement 14, which are located on the left-hand side in the drawing, at the same time.

When the central position of the one surface-side electrode 2 to be inspected is misregistered from the central position of the set 12 of connecting electrodes to the upper side in the drawing as illustrated in Fig. 4(c), the one surface-side electrode 2 to be inspected is electrically connected to both electrode for current supply 13 and electrode for voltage measurement 14, which are located on the upper side in the drawing, at the same time.

When the central position of the one surface-side electrode 2 to be inspected is misregistered from the central position of the set 12 of connecting electrodes to the lower side in the drawing as illustrated in Fig. 4(d), the one surface-side electrode 2 to be inspected is electrically connected to both electrode for current supply 13 and electrode for voltage measurement 14, which are located on the lower side in the drawing, at the same time.

According to the connector 10 for measurement of electric resistance according to the first embodiment, thus, tolerance for misregistration to the one surface-side electrodes 2 to be inspected in an electrically connecting operation to the circuit board 1 to be inspected is high, so that electrical connection of both electrode 13 for current supply and electrode 14 for voltage measurement to the one surface-side electrode 2 to be inspected can be surely achieved even when the circuit board 1 to be inspected is large in area and has a great number of small-sized one surface-side electrodes 2 to be inspected. In addition, since the electrode 13 for current supply and the electrode 14 for voltage measurement are electrically insulated from each other, the electric resistance as to the circuit board 1 to be inspected can be measured with high precision.

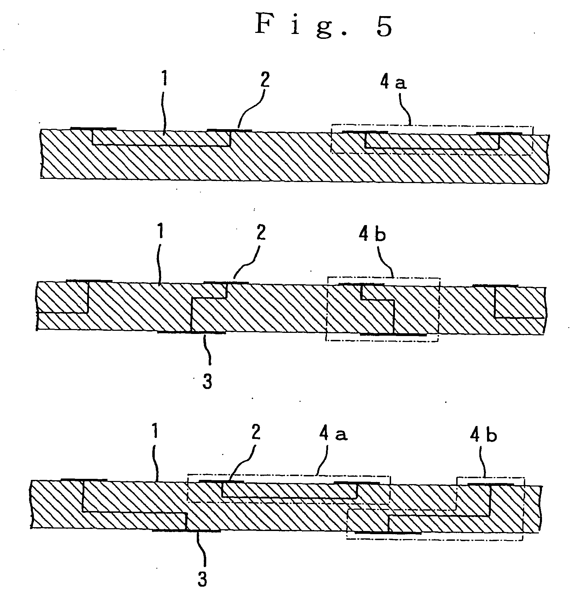

In the present invention, the circuit board 1 to be inspected, the electric resistance of which should be measured, may be any of a circuit board having only one surface-side electrodes 2 to be inspected formed on one surface thereof and having only circuits 4a formed between the one surface-side electrodes 2 to be inspected as illustrated in Fig. 5(a), a circuit board having one surface-side electrodes 2 to be inspected formed on one surface thereof and other surface-side electrodes 3 to be inspected formed on the other surface and having only circuits 4b formed between the one surface-side electrode 2 to be inspected and the other surface-side electrode 3 to be inspected as illustrated in Fig. 5(b), and a circuit board having one surface-side electrodes 2 to be inspected formed on one surface thereof and the other surface-side electrodes 3 to be inspected formed on the other surface and having both circuits 4a formed between the one surface-side electrodes 2 to be inspected and circuits 4b formed between the one surface-side electrode 2 to be inspected and the other surface-side electrode 3 to be inspected as illustrated in Fig. 5 (c) .

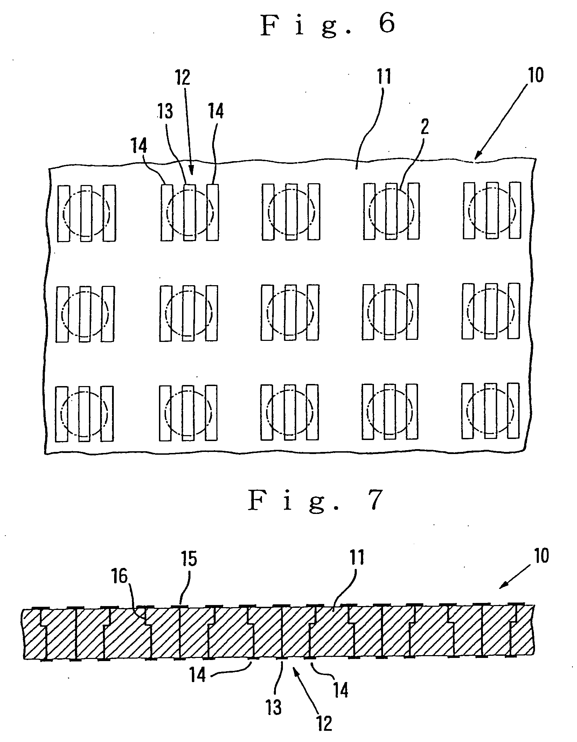

Fig. 6 is a plan view illustrating a connector for measurement of electric resistance according to a second embodiment of the present invention, and Fig. 7 is a cross-sectional view illustrating the construction of the connector for measurement of electric resistance according to the second embodiment.

In the connector 10 for measurement of electric resistance according to the second embodiment, plural sets 12 of connecting electrodes are arranged on a front surface of an insulating substrate 11 in accordance with a pattern corresponding to a pattern of one surface-side electrodes 2 (indicated by an alternate long and short dash line) to be inspected formed on one surface of a circuit board, the electric resistance of which should be measured. These sets 12 of connecting electrodes are each composed of 3 electrodes in total of a rectangular electrode 13 for current supply and 2 rectangular electrodes 14 for voltage measurement as illustrated in Fig. 6. These 3 electrodes are arranged in a state separated from one another so as to align in order of the electrode 14 for voltage measurement, the electrode 13 for current supply and the electrode 14 for voltage measurement.

On a back surface of the insulating substrate 11, a plurality of relay electrodes 15 are arranged in accordance with a proper pattern as illustrated in Fig. 7, and either one of the electrode 13 for current supply and the electrode 14 for voltage measurement is electrically connected to each of these relay electrodes 15 through a wiring part 16 formed in the insulating substrate 11.

In the above, a material for the insulating substrate 11 and a material for the respective electrodes in the sets 12 of connecting electrodes are the same as in the connector for measurement of electric resistance according to the first embodiment.

According to the connector 10 for measurement of electric resistance according to the second embodiment, in each of the sets 12 of connecting electrodes, the 3 electrodes of the electrode 14 for voltage measurement, the electrode 13 for current supply and the electrode 14 for voltage measurement are arranged so as to align in this order, so that a one surface-side electrode 2 to be inspected is electrically connected to both of the electrode 13 for current supply and at least one electrode 14 for voltage measurement at the same time even when the one surface-side electrode 2 to be inspected is misregistered in the arrangement direction (lateral direction in Fig. 6) of the respective electrodes of the sets 12 of connecting electrodes.

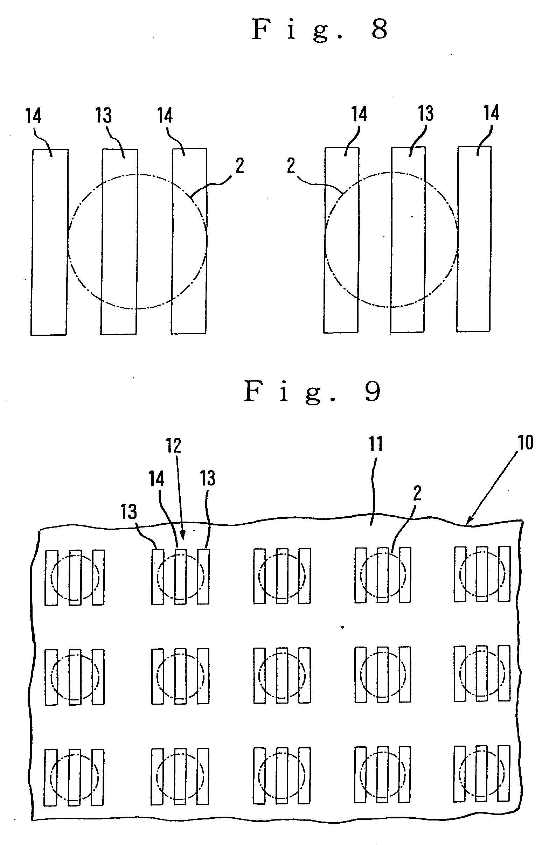

Specifically described, when the central position of the one surface-side electrode 2 to be inspected is misregistered from the central position of the set 12 of connecting electrodes to the right-hand side in the drawing as illustrated in Fig. 8(a), the one surface-side electrode 2 to be inspected is electrically connected to both of the electrode 13 for current supply, which is located at the center, and the electrode 14 for voltage measurement, which is located on the right-hand side in the drawing, at the same time.

When the central position of the one surface-side electrode 2 to be inspected is misregistered from the central position of the set 12 of connecting electrodes to the left-hand side in the drawing as illustrated in Fig. 8(b), the one surface-side electrode 2 to be inspected is electrically connected to both of the electrode 13 for current supply, which is located at the center, and the electrode 14 for voltage measurement 14, which is located on the left-hand side in the drawing, at the same time.

In addition, since each of the electrodes 13 for current supply and the electrodes 14 for voltage measurement has a rectangular form long in a direction perpendicular to the arrangement direction of these electrodes, a one surface-side electrode 2 to be inspected is electrically connected to both of the electrode 13 for current supply and the electrode 14 for voltage measurement at the same time even when the central position of the one surface-side electrode 2 to be inspected is misregistered from the central position of the set 12 of connecting electrodes to a direction (vertical direction in Fig. 6) perpendicular to the arrangement direction of the respective electrodes of the set 12 of connecting electrodes.

According to the connector 10 for measurement of electric resistance according to the second embodiment, thus, tolerance for misregistration to the one surface-side electrodes 2 to be inspected in an electrically connecting operation to the circuit board 1 to be inspected is high, so that electrical connection of both electrode 13 for current supply and electrode 14 for voltage measurement to the one surface-side electrode 2 to be inspected can be surely achieved even when the circuit board 1 to be inspected is large in area and has a great number of small-sized one surface-side electrodes 2 to be inspected. In addition, since the electrode 13 for current supply and the electrode 14 for voltage measurement are electrically insulated from each other, the electric resistance as to the circuit board 1 to be inspected can be measured with high precision.

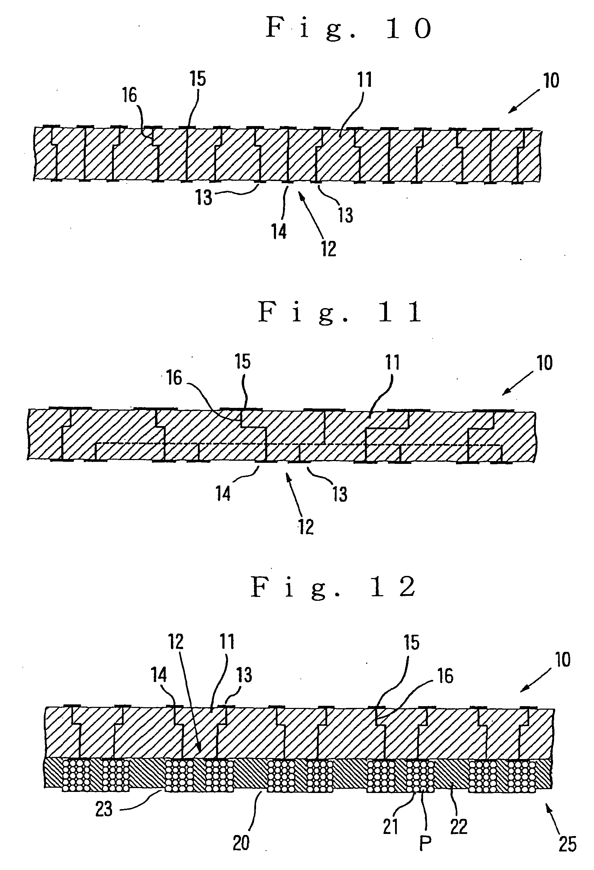

Fig. 9 is a plan view illustrating a connector for measurement of electric resistance according to a third embodiment of the present invention, and Fig. 10 is a cross-sectional view illustrating the construction of the connector for measurement of electric resistance according to the third embodiment.

In the connector 10 for measurement of electric resistance according to the third embodiment, plural sets 12 of connecting electrodes are arranged on a front surface of an insulating substrate 11 in accordance with a pattern corresponding to a pattern of one surface-side electrodes 2 (indicated by an alternate long and short dash line) to be inspected formed on one surface of a circuit board, the electric resistance of which should be measured. These sets 12 of connecting electrodes are each composed of 3 electrodes in total of 2 rectangular electrodes 13 for current supply and a rectangular electrode 14 for voltage measurement as illustrated in Fig. 9. These 3 electrodes are arranged in a state separated from one another so as to align in order of the electrode 13 for current supply, the electrode 14 for voltage measurement and the electrode 13 for current supply.

On a back surface of the insulating substrate 11, a plurality of relay electrodes 15 are arranged in accordance with a proper pattern as illustrated in Fig. 10, and either one of the electrode 13 for current supply and the electrode 14 for voltage measurement is electrically connected to each of these relay electrodes 15 through a wiring part 16 formed in the insulating substrate 11.

In the above, a material for the insulating substrate 11 and a material for the respective electrodes in the sets 12 of connecting electrodes are the same as in the connector for measurement of electric resistance according to the first embodiment.

According to the connector 10 for measurement of electric resistance according to the third embodiment, in each set 12 of the connecting electrodes, the 3 electrodes of the electrode 13 for current supply, the electrode 14 for voltage measurement and the electrode 13 for current supply are arranged so as to align in this order, so that a one surface-side electrode 2 to be inspected is electrically connected to both of at least one electrode 13 for current supply and the electrode 14 for voltage measurement at the same time even when the one surface-side electrode 2 to be inspected is misregistered in the arrangement direction (lateral direction in Fig. 9) of the respective electrodes.

In addition, since each of the electrodes 13 for current supply and the electrode 14 for voltage measurement has a rectangular form long in a direction perpendicular to the arrangement direction of these electrodes, a one surface-side electrode 2 to be inspected is electrically connected to both of the electrode 13 for current supply and the electrode 14 for voltage measurement at the same time even when the central position of the one surface-side electrode 2 to be inspected is misregistered from the central position of the set 12 of connecting electrodes to a direction (vertical direction in Fig. 9) perpendicular to the arrangement direction of the respective electrodes.

According to the connector 10 for measurement of electric resistance according to the third embodiment, thus, tolerance for misregistration to the one surface-side electrodes 2 to be inspected in an electrically connecting operation to the circuit board 1 to be inspected is high, so that electrical connection of both electrode 13 for current supply and electrode 14 for voltage measurement to the one surface-side electrode 2 to be inspected can be surely achieved even when the circuit board 1 to be inspected is large in area and has a great number of small-sized one surface-side electrodes 2 to be inspected. In addition, since the electrode 13 for current supply and the electrode 14 for voltage measurement are electrically insulated from each other, the electric resistance as to the circuit board 1 to be inspected can be measured with high precision.

Fig. 11 is a cross-sectional view illustrating the construction of a connector for measurement of electric resistance according to a fourth embodiment of the present invention.

In the connector for measurement of electric resistance according to the fourth embodiment, sets 12 of connecting electrodes of the same construction as in the connector for measurement of electric resistance according to the first embodiment are formed on a front surface of an insulating substrate 11 (see Fig. 1). On a back surface of the insulating substrate 11, a plurality of relay electrodes 15 are arranged in accordance with a proper pattern, either one of the electrode 13 for current supply and the electrode 14 for voltage measurement is electrically connected to each of these relay electrodes 15 through a wiring part 16 formed in the insulating substrate 11, and a plurality of the electrodes 13 for current supply are electrically connected to some relay electrodes 15 among these relay electrodes 15.

In the above, a material for the insulating substrate 11 and a material for the respective electrodes in the sets 12 of connecting electrodes are the same as in the connector for measurement of electric resistance according to the first embodiment.

According to the connector 10 for measurement of electric resistance according to the fourth embodiment, tolerance for misregistration to the electrodes to be inspected in an electrically connecting operation to the circuit board to be inspected is high, so that electrical connection of both electrode 13 for current supply and electrode 14 for voltage measurement to the electrode to be inspected can be surely achieved even when the circuit board to be inspected is large in area and has a great number of small-sized electrodes to be inspected. In addition, since the electrode 13 for current supply and the electrode 14 for voltage measurement are electrically insulated from each other, the electric resistance as to the circuit board to be inspected can be measured with high precision.

Further, since the connector has the relay electrode 15 electrically connected to a plurality of the electrodes 13 for current supply, the number of inspection electrodes in a circuit board for inspection, to which the connector 10 for measurement of electric resistance is electrically connected, can be lessened, whereby the production of the circuit board for inspection becomes easy, and the production cost of the circuit board for inspection can be reduced.

The connectors for measurement of electric resistance according to the present invention are not limited to the above-described embodiments, and various changes or modifications may be added thereto.

For example, the total number of electrodes in the set of connecting electrodes may be 5 or more so far as the set comprises at least one electrode for current supply and at least one electrode for voltage measurement.

In addition, the form of the electrodes for current supply and electrodes for voltage measurement is not limited to the rectangle, and it may be a circle or any other form.

Further, the arrangement pattern of the electrodes in the set of connecting electrodes may be suitably set according to the number and form of the electrodes, the form of the electrodes to be inspected, etc.

Still further, a plurality of electrodes for voltage measurement may be electrically connected to one relay electrode.

### <Connector device for measurement of electric resistance>

Fig. 12 is a cross-sectional view illustrating the construction of a connector device for measurement of electric resistance according to a first embodiment of the present invention. This connector device 25 for measurement of electric resistance is made up of the connector 10 for measurement of electric resistance according to the first embodiment and an anisotropically conductive elastomer layer 20 integrally formed on a front surface (lower surface in Fig. 12) of this connector 10 for measurement of electric resistance.

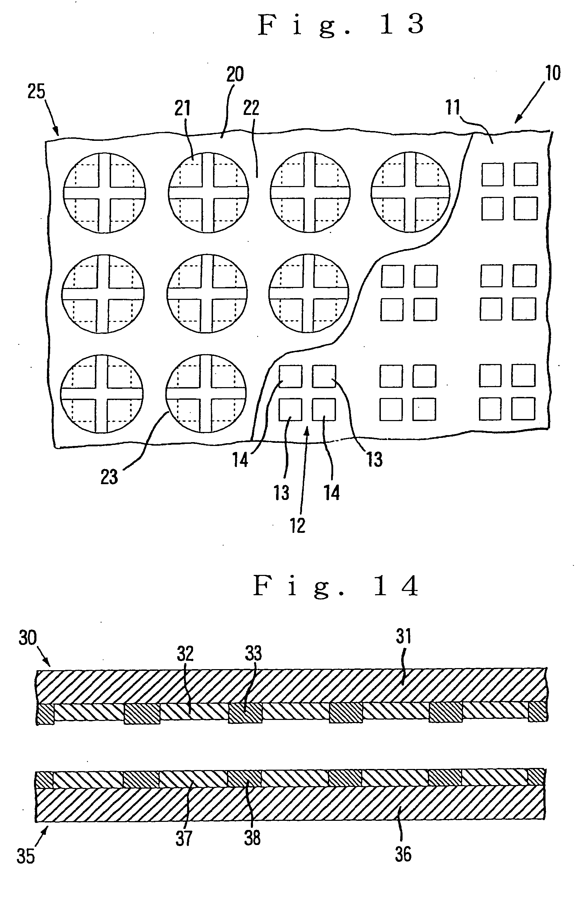

As illustrated in Fig. 13 as well, the anisotropically conductive elastomer layer 20 is composed of a plurality of conductive path-forming parts 21 arranged in accordance with a pattern corresponding to a pattern of the electrodes 13 for current supply and the electrodes 14 for voltage measurement in the respective sets 12 of connecting electrodes and each extending in a thickness-wise direction of the elastomer layer, and an insulating part 22 intervening among these conductive path-forming parts 21 and mutually insulating these conductive path-forming parts. In the embodiment illustrated, projected parts 23 are formed on the surface of the anisotropically conductive elastomer layer 20 in such a manner that the surfaces of 4 conductive path-forming parts 21 corresponding to the respective electrodes in one set 12 of connecting electrodes and the surfaces of insulating portions 22 intervening among them protrude from the surfaces of other insulating portions 22.

The conductive path-forming parts 21 are formed by causing conductive particles P exhibiting magnetism to be densely contained in an elastic polymeric substance making up a base of the anisotropically conductive elastomer layer 20 in a state oriented so as to align in a thickness-wise direction thereof. A conductive path is formed by a chain of the conductive particles P. On the other hand, the insulating part 22 does not contain the conductive particles P at all or scarcely contain them.

As examples of the conductive particles P making up the conductive path-forming parts 21, may be mentioned particles of metals exhibiting magnetism, such as nickel, iron and cobalt, particles of alloys thereof and particles containing such a metal; particles obtained by using these particles as core particles and plating the surfaces of the core particles with a metal having good conductivity, such as gold, silver, palladium or rhodium; and particles obtained by using particles of a non-magnetic metal, inorganic particles such as glass beads or polymer particles as core particles and plating the surfaces of the core particles with a conductive magnetic substance such as nickel or cobalt.

Among these, particles obtained by using nickel particles as core particles and plating the surfaces thereof with a metal having good conductivity, such as gold or silver are preferably used.

The particle diameter of the conductive particles P is preferably 3 to 200 µm, particularly preferably 10 to 100 µm in order that deformation under pressure of the resulting conductive path-forming parts 21 is made easy, and sufficient electrical contact is achieved among the conductive particles P in the conductive path-forming parts 21.

The water content in the conductive particles P is preferably at most 5%, more preferably at most 3%, still more preferably at most 2%, particularly preferably at most 1%. The use of the conductive particles satisfying such conditions can prevent or inhibit the occurrence of bubbles in the first upper-side anisotropically conductive sheet 20 upon the formation thereof.

The proportion of the conductive particles P in the conductive path-forming parts 21 is preferably 5 to 60%, more preferably 7 to 50%, particularly preferably 10 to 40% in terms of volume fraction. If this proportion is less than 5%, it may be difficult in some cases to form conductive paths sufficiently low in electric resistance value. If the proportion is greater than 60% on the other hand, the resulting conductive path-forming parts 21 become brittle, so that elasticity required of the conductive path-forming parts may not be achieved in some cases.

The insulating elastic polymeric substance making up the base of the anisotropically conductive elastomer layer 20 preferably has a crosslinked structure. As polymeric substance-forming materials usable for obtaining the polymeric substance having the crosslinked structure, may be used various materials. Specific examples thereof include conjugated diene rubbers such as polybutadiene rubber, natural rubber, polyisoprene rubber, styrene-butadiene copolymer rubber and acrylonitrile-butadiene copolymer rubber, and hydrogenated products thereof; block copolymer rubbers such as styrene-butadiene block copolymer rubber, and hydrogenated products thereof; and besides silicone rubber, fluororubber, silicone-modified fluororubber, ethylene-propylene copolymer rubber, urethane rubber, polyester rubber, chloroprene rubber and epichlorohydrin rubber.

Among these, silicone rubber and silicone-modified fluororubber are preferably used in that they are high in molding and processing ability and electrical insulating properties.

According to such a connector device 25 for measurement of electric resistance according to the first embodiment, the connector for measurement of electric resistance according to the first embodiment is provided, so that tolerance for misregistration to the electrodes to be inspected in an electrically connecting operation to the circuit board to be inspected, the electric resistance of which should be measured, is high, and so electrical connection of both electrode 13 for current supply and electrode 14 for voltage measurement to the electrode to be inspected can be surely achieved even when the circuit board to be inspected is large in area and has a great number of small-sized one surface-side electrodes to be inspected. In addition, since the electrode 13 for current supply and the electrode 14 for voltage measurement are electrically insulated from each other, the electric resistance as to the circuit board 1 to be inspected can be measured with high precision.

Further, since the anisotropically conductive elastomer layer 20 is integrally formed on the front surface of the connector 10 for measurement of electric resistance, good electrical connection can be stably retained even on an environmental change such as thermal hysteresis by temperature change.

Still further, since the conductive path-forming parts 21 are formed in the anisotropically conductive elastomer layer 20 corresponding to the electrodes 13 for current supply and the electrodes 14 for voltage measurement in the connector 10 for measurement of electric resistance, the,insulating property between the electrode 13 for current supply and the electrode 14 for voltage measurement is secured. As a result, the electric resistance as to the circuit board to be inspected can be measured with higher precision.

The connector device for measurement of electric resistance according to the first embodiment can be produced, for example, in the following manner.

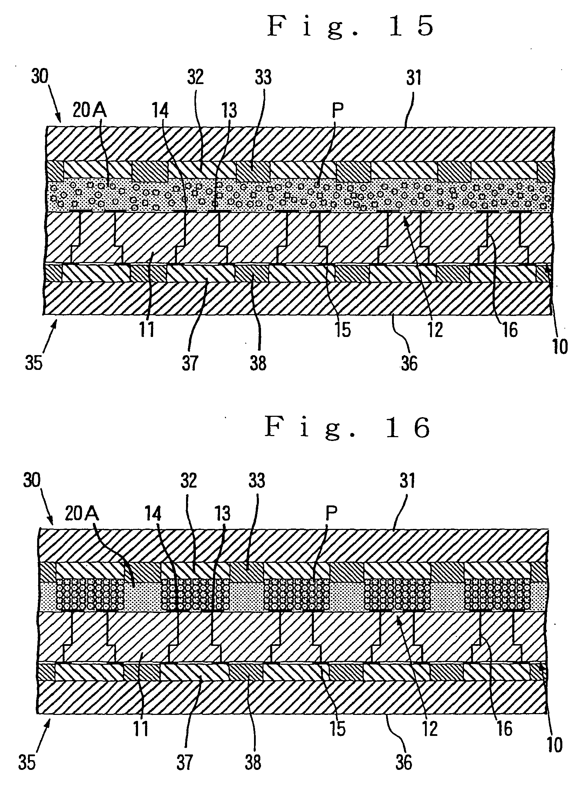

Fig. 14 is a cross-sectional view illustrating the construction of an exemplary mold for obtaining the anisotropically conductive elastomer layer 20. This mold is made up by arranging a top force 30 and a bottom force 35 making a pair therewith so as to oppose to each other.

In the top force 30, ferromagnetic substance layers 32 are formed on the surface (lower surface in Fig. 14) of a ferromagnetic base plate 31 in accordance with a pattern antipodal to a pattern of regions, in which the sets 12 of connecting electrodes in the connector 10 for measurement of electric resistance have been formed, and non-magnetic substance layers 33 are formed in other regions than the regions, in which the ferromagnetic substance layers 32 have been formed. The non-magnetic substance layers 33 have a thickness greater than the thickness of the ferromagnetic substance layers 32. A difference in level is defined between the ferromagnetic substance layer 32 and the non-magnetic substance layer 33, whereby recessed parts for forming the projected parts 23 in the anisotropically conductive elastomer layer 20 are formed in the molding surface of the top force 30.

In the bottom force 35, ferromagnetic substance layers 37 are formed on the surface (upper surface in Fig. 14) of a ferromagnetic base plate 36 in accordance with the same pattern as the pattern of the regions, in which the sets 12 of connecting electrodes in the connector 10 for measurement of electric resistance have been formed, and non-magnetic substance layers 38 having substantially the same thickness as the ferromagnetic substance layers 37 are formed in other regions than the regions, in which the ferromagnetic substance layers 37 have been formed.

As materials for forming the ferromagnetic base plates 31, 36 in both top force 30 and bottom force 35, may be used ferromagnetic metals such as iron, iron-nickel alloys, iron-cobalt alloys, nickel and cobalt. The ferromagnetic base plates 31, 36 preferably have a thickness of 0.1 to 50 mm, and surfaces thereof are preferably smooth and subjected to a chemical degreasing treatment and/or mechanical polishing treatment.

As materials for forming the ferromagnetic substance layers 32, 37 in both top force 30 and bottom force 35, may be used ferromagnetic metals such as iron, iron-nickel alloys, iron-cobalt alloys, nickel and cobalt. The ferromagnetic substance layers 32, 37 preferably have a thickness of at least 10 µm. If this thickness is less than 10 µm, it is difficult to apply a magnetic field having a sufficient intensity distribution to a material layer for elastomer, which will be described subsequently, and so it is difficult to gather the conductive particles at a high density to portions, which will become conductive path-forming parts, in the material layer for elastomer. As a result, conductive path-forming parts having good conductivity may not be provided in some cases.

As materials for forming the non-magnetic substance layers 33, 38 in both top force 30 and bottom force 35, may be used non-magnetic metals such as copper, polymeric substances having heat resistance, and the like. However, a polymeric substance cured by radiation may preferably be used in that the non-magnetic substance layers 33, 38 can be easily formed by a technique of photolithography. As a material thereof, may be used, for example, a photoresist such as an acrylic type dry film resist, epoxy type liquid resist or polyimide type liquid resist.

The connector device for measurement of electric resistance can be produced by using the above-described mold, for example, in the following manner.

The connector 10 for measurement of electric resistance according to the first embodiment as illustrated in Fig. 1 is first produced, and a material for elastomer is prepared by causing conductive particles having magnetism to be contained in a liquid polymeric substance-forming material, which will become an elastic polymeric substance by being cured.

As illustrated in Fig. 15, the material for elastomer is then applied on to a front surface of the connector 10 for measurement of electric resistance, thereby forming a material layer 20A for elastomer having a necessary thickness, and the top force 30 and the bottom force 35 are arranged on the surface (upper surface in Fig. 15) of the material layer 20A for elastomer and the back surface of the connector 10 for measurement of electric resistance, respectively.

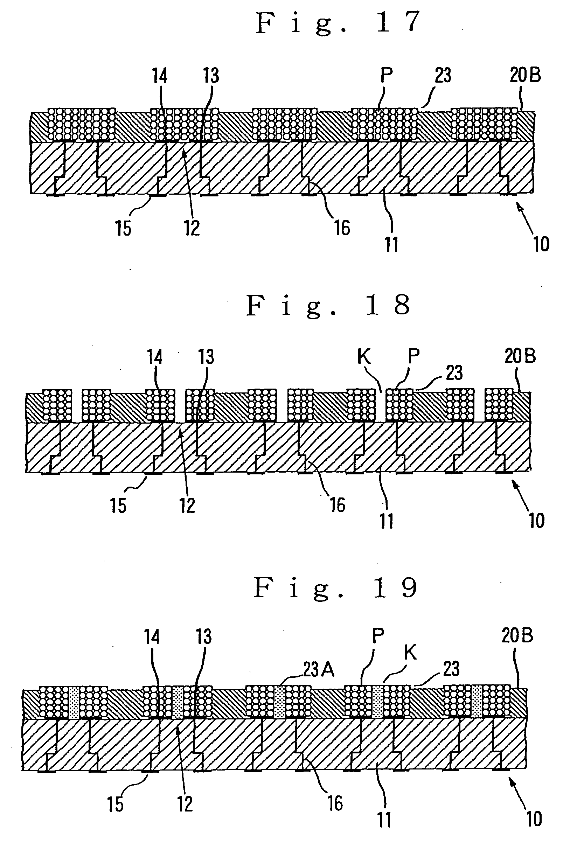

For example, electromagnets are arranged on an upper surface of the top force 30 and a lower surface of the bottom force 35, respectively, and the electromagnets are operated, thereby applying a magnetic field having higher intensity at portions located between the ferromagnetic substance layers 32 of the top force 30 and their corresponding ferromagnetic substance parts 37 of the bottom force 35, i.e., portions located on the surfaces of the regions (hereinafter also referred to as "connecting electrode set regions"), in which the sets 12 of connecting electrodes of the connector 10 for measurement of electric resistance have been respectively formed, than the other portions, to the material layer 20A for elastomer in a thickness-wise direction thereof. As a result, the conductive particles P dispersed in the material layer 20A for elastomer are gathered at the portions located on the surfaces of the connecting electrode set regions as illustrated in Fig. 16 and oriented so as to align in the thickness-wise direction. In this state, the material layer 20A for elastomer is subjected to a curing treatment, thereby forming, on the front surface of the connector 10 for measurement of electric resistance, an elastomer layer 20B containing the conductive particles exhibiting magnetism in a state oriented so as to align in the thickness-wise direction at the portions located on the surfaces of the connecting electrode set regions as illustrated in Fig. 17.

In the above-described process, the viscosity of the material for elastomer is preferably within a range of 100,000 to 1,000,000 cp at a temperature of 25°C.

No particular limitation is imposed on a method for applying the material for elastomer, and for example, a roll coating method, a blade coating method or a printing method such as screen printing may be used.

The intensity of the magnetic field applied to the material layer 20A for elastomer is preferably an intensity that it amounts to 20 to 2,000 mT on the average.

As means for applying the magnetic field, permanent magnets may be used in place of the electromagnets. As such permanent magnets, are preferred those composed of alunico (Fe-Al-Ni-Co alloy), ferrite or the like in that the intensity of the magnetic field within the above range is achieved.

The curing treatment of the material layer 20A for elastomer may be conducted in the state that the magnetic field has been applied. However, the treatment may also be conducted after stopping the application of the magnetic field.

Conditions for the curing treatment of the material layer 20A for elastomer are suitably selected according to the material used. However, the treatment is generally conducted by a heat treatment. Specific heating temperature and heating time are suitably selected in view of the kind of the polymeric substance-forming material for the material layer 20A for elastomer, the time required for movement of the conductive particles, and the like. For example, when the polymeric substance-forming material is room temperature-curing silicone rubber, the curing treatment of the material layer for elastomer is performed for about 24 hours at room temperature, for about 2 hours at 40°C and for about 30 minutes at 80°C.

With respect to the elastomer layer 20B formed on the front surface of the connector 10 for measurement of electric resistance in such a manner, portions located on the surfaces of regions between the respective electrodes (electrodes 13 for current supply and electrodes 14 for voltage measurement) of the sets 12 of connecting electrodes in the portions containing the conductive particles P are removed as illustrated in Fig. 18, thereby forming hole portions K of a cross form. A liquid polymeric substance-forming material 23A, which will become an elastic polymeric substance by being cured, is then filled into the hole portions K as illustrated in Fig. 19, and thereafter, the liquid polymeric substance-forming material 23A is subjected to a curing treatment, thereby forming an anisotropically conductive elastomer layer 20 with an insulating part 22 formed between adjacent conductive path-forming parts 21, thus producing the connector device 25 for measurement of electric resistance illustrated in Figs. 12 and 13.

In the above-described process, laser beam machining by means of carbon dioxide gas laser or the like is preferably used as a method for forming the hole portions K in the elastomer layer 20B.

The polymeric substance-forming material filled into the hole portions K may be the same or different from the polymeric substance-forming material used as the material for elastomer.

According to such a process, the elastomer layer 20B having portions containing the conductive particles P on the surfaces of the connecting electrode set regions of the connector 10 for measurement of electric resistance is formed, the hole portions K are formed between portions, in portions containing conductive particles P, to become the conductive path-forming parts, which are located on the surfaces of the electrodes 13 for current supply and the electrodes 14 for voltage measurement, in the elastomer layer 20B, and the insulating part 22 is formed in the hole portions K, so that the anisotropically conductive elastomer layer 20 with necessary insulating property secured between adjoining conductive path-forming parts 21 can be surely formed.

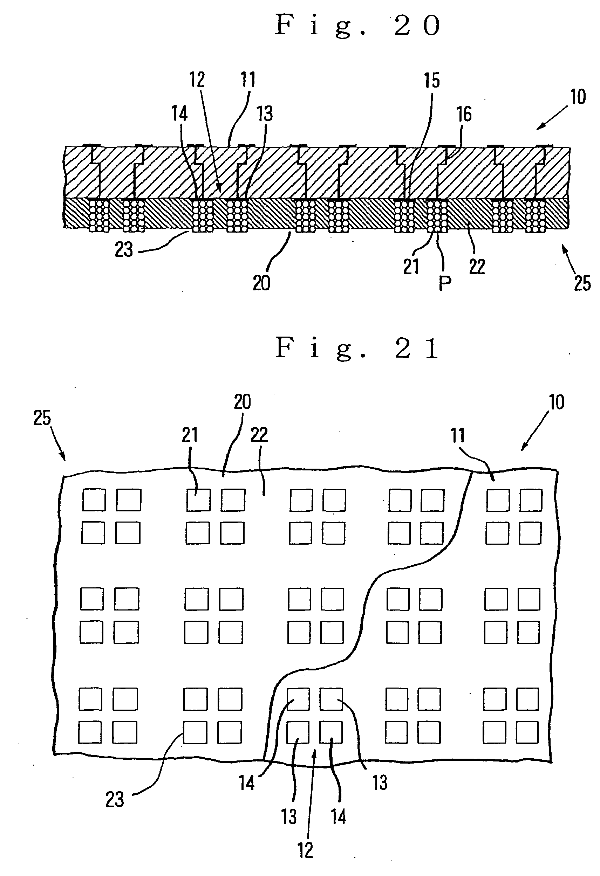

Fig. 20 is a cross-sectional view illustrating the construction of a connector device for measurement of electric resistance according to a second embodiment of the present invention. This connector device 25 for measurement of electric resistance is made up of the connector 10 for measurement of electric resistance according to the first embodiment and an anisotropically conductive elastomer layer 20 integrally formed on a front surface (lower surface in Fig. 20) of this connector 10 for measurement of electric resistance.

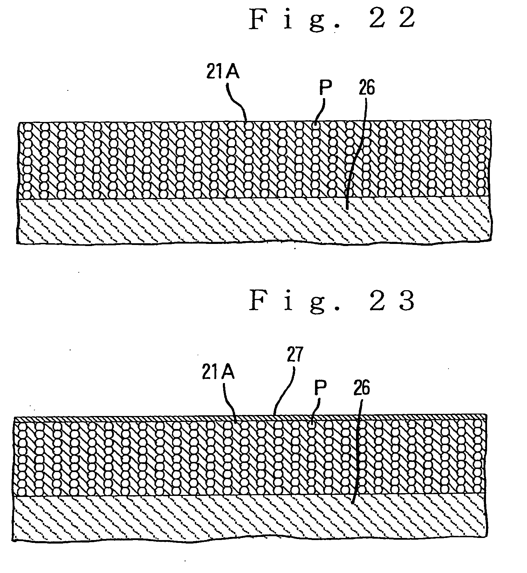

As illustrated in Fig. 21 as well, the anisotropically conductive elastomer layer 20 is composed of a plurality of conductive path-forming parts 21 arranged in accordance with a pattern corresponding to a pattern of the electrodes 13 for current supply and the electrodes 14 for voltage measurement in the respective sets 12 of connecting electrodes and each extending in a thickness-wise direction thereof, and an insulating part 22 intervening among these conductive path-forming parts 21 and mutually insulating these conductive path-forming parts. In the embodiment illustrated, projected parts 23 are formed on the anisotropically conductive elastomer layer 20 in such a manner that the surfaces of the conductive path-forming parts 21 protrude from the surface of the insulating part 22.

The conductive path-forming parts 21 are formed by causing conductive particles P exhibiting magnetism to be contained at high density in an elastic polymeric substance making up a base of the anisotropically conductive elastomer layer 20 in a state oriented so as to align in a thickness-wise direction of the elastomer layer. A conductive path is formed by a chain of the conductive particles P. On the other hand, the insulating part 22 does not contain the conductive particles P at all.

As the elastic polymeric substance making up the base of the anisotropically conductive elastomer layer 20 and the conductive particles making up the conductive path-forming parts 21, may be used the same substance and particles in the anisotropically conductive elastomer layer 20 in the above-described connector device for measurement of electric resistance according to the first embodiment.

According to such a connector device 25 for measurement of electric resistance according to the second embodiment, the connector for measurement of electric resistance according to the first embodiment is provided, so that tolerance for misregistration to the electrodes to be inspected in an electrically connecting operation to the circuit board to be inspected, the electric resistance of which should be measured, is high, and so electrical connection of both electrode 13 for current supply and electrode 14 for voltage measurement to the electrode to be inspected can be surely achieved even when the circuit board to be inspected is large in area and has a great number of small-sized one surface-side electrodes to be inspected. In addition, since the electrode 13 for current supply and the electrode 14 for voltage measurement are electrically insulated from each other, the electric resistance as to the circuit board 1 to be inspected can be measured with high precision.

Further, since the anisotropically conductive elastomer layer 20 is integrally formed on the front surface of the connector 10 for measurement of electric resistance, good electrical connection can be stably retained even on an environmental change such as thermal hysteresis by temperature change.

Still further, since the conductive path-forming parts 21 are formed in the anisotropically conductive elastomer layer 20 corresponding to the electrodes 13 for current supply and the electrodes 14 for voltage measurement in the connector 10 for measurement of electric resistance, the insulating property between the electrode 13 for current supply and the electrode 14 for voltage measurement is secured. As a result, the electric resistance as to the circuit board to be inspected can be measured with higher precision.

The connector device for measurement of electric resistance according to the second embodiment can be produced, for example, in the following manner.

A proper releasable supporting plate 26 is first provided as illustrated in Fig. 22, and a conductive elastomer layer 21A with conductive particles P contained in an elastic polymeric substance in a state oriented so as to align in a thickness-wise direction is formed on the surface of this releasable supporting plate 26 in a state releasably supported on the releasable supporting plate 26. This conductive elastomer layer 21A has the same thickness as the thickness of the conductive path-forming parts to be formed.

In the above-described process, as a material for forming the releasable supporting plate 26, may be used a metal, ceramic, resin or a composite material thereof.

As a process for forming the conductive elastomer layer 21A, may be used (1) a process that a conductive elastomer sheet produced in advance by a proper process, in which conductive particles P are contained in an elastic polymeric substance in a state oriented so as to align in a thickness-wise direction of the sheet, is releasably stuck on the surface of a releasable supporting plate 26, (2) a process that a material for conductive elastomer with conductive particles exhibiting magnetism dispersed in a liquid polymeric substance-forming material, which will become an elastic polymeric substance by being cured, is prepared, this material for conductive elastomer is applied on to a releasable supporting plate 15, thereby forming a material layer for conductive elastomer, a magnetic field is applied to the material layer for conductive elastomer in the thickness-wise direction thereof, thereby orienting the conductive particles P in the material layer for conductive elastomer so as to align in the thickness-wise direction, and the material layer for conductive elastomer is subjected to a curing treatment in this state, or the like.

In the process (1), as means for sticking the conductive elastomer sheet on the surface of the releasable supporting plate 26, may be used a method of utilizing the adhesion property of the conductive elastomer sheet itself to stick it, a method of sticking it with an adhesive, or the like.

In the above process (2), as specific means for applying the material for conductive elastomer, may be used a printing method such as screen printing, roll coating method, blade coating method or the like.

As means for applying the magnetic field to the material layer for conductive elastomer, may be used electromagnets, permanent magnets or the like.

The intensity of the magnetic field applied to the material layer for conductive elastomer is preferably an intensity that it amounts to 0.2 to 2.5 T.

The curing treatment of the material layer for conductive elastomer is generally conducted by a heating treatment. Specific heating temperature and heating time are suitably preset in view of the kind of the polymeric substance-forming material forming the material layer for conductive elastomer, the time required for movement of the conductive particles, etc..

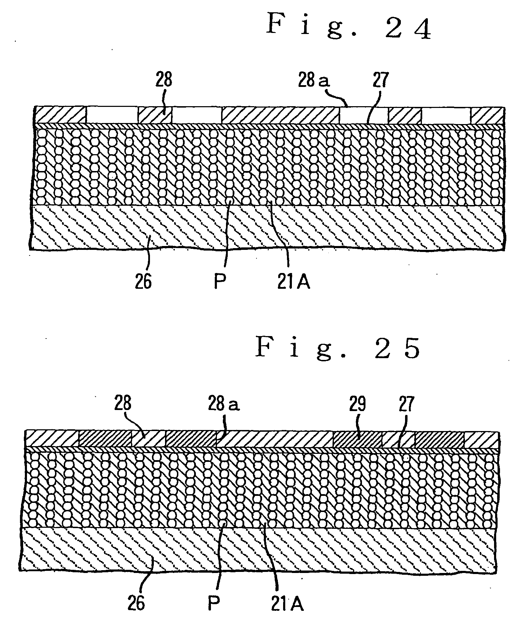

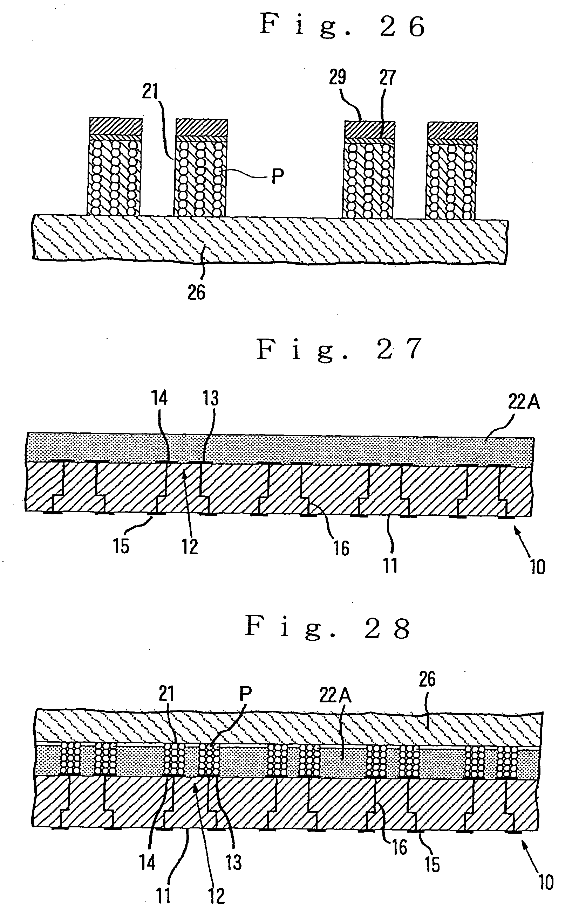

A metallic thin layer 27 for plating electrode is formed on the surface of the conductive elastomer layer 21A formed on the releasable supporting plate 26 in such a manner as illustrated in Fig. 23. A resist layer 28, in which a plurality of openings 28a have been formed in accordance with a pattern of conductive path-forming parts to be formed, i.e., a pattern corresponding to the electrodes for current supply and electrodes for voltage measurement in the connector for measurement of electric resistance, is formed on this metallic thin layer 27 by photolithography as illustrated in Fig. 24. Thereafter, the metallic thin layer 27 is used as a plating electrode to subject portions exposed through the openings 28a of the resist layer 28 in the metallic thin layer 27 to an electroplating treatment, thereby forming metal masks 29 within the openings 28a of the resist layer 28 as illustrated in Fig. 25. In this state, the conductive elastomer layer 21A, metallic thin layer 27 and resist layer 28 are subjected to laser beam machining, thereby removing parts of the resist layer 28, metallic thin layer 27 and conductive elastomer layer 21A. As a result, a plurality of conductive path-forming parts 21 arranged in accordance with the pattern corresponding to the electrodes for current supply and electrodes for voltage measurement in the connector for measurement of electric resistance are formed in a state supported on the releasable supporting plate 26 as illustrated in Fig. 26. Thereafter, the remaining metallic thin layer 27 and metal masks 29 are removed from the surfaces of the conductive path-forming parts 21.

In the above-described process, as a method for forming the metallic thin layer 27 on the surface of the conductive elastomer layer 21A, may be used an electroless plating method, sputtering method or the like.

As a material for forming the metallic thin layer 27, may be used copper, gold, aluminum, rhodium or the like.

The thickness of the metallic thin layer 27 is preferably 0.05 to 2 µm, more preferably 0.1 to 1 µm. If this thickness is too small, no uniform thin layer is formed, and such a thin layer may be unsuitable for use as a plating electrode in some cases. If this thickness is too great on the other hand, it may be difficult in some cases to remove such a metallic thin layer by laser beam machining.

The thickness of the resist layer 28 is preset according to the thickness of the metal masks 29 to be formed.

As a material for forming the metal masks 29, may be used copper, iron, aluminum, gold, rhodium or the like.

The thickness of the metal masks 29 is preferably at least 2 µm, more preferably 5 to 20 µm. If this thickness is too small, such metal masks may be unsuitable for use as masks against laser in some cases.

The laser beam machining is preferably conducted by carbon dioxide gas laser, whereby conductive path-forming parts 21 of the intended form can be surely formed.

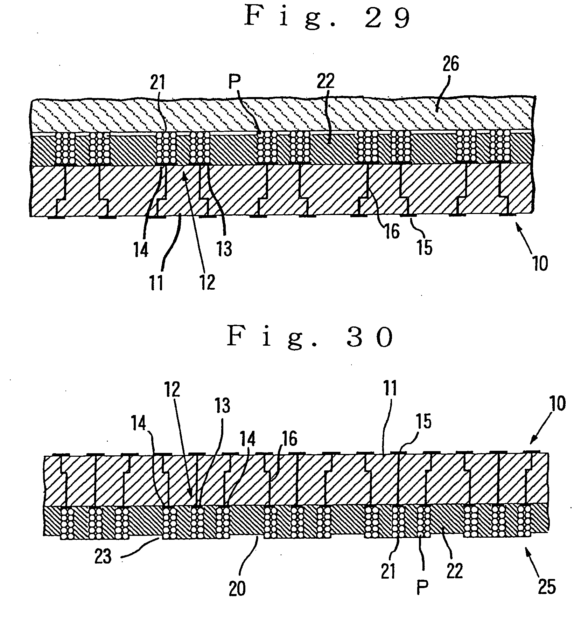

On the other hand, a liquid polymeric substance-forming material, which will become an insulating elastic polymeric substance by being cured, is applied on to the surface of the connector 10 for measurement of electric resistance as illustrated in Fig. 27, thereby forming a material layer 22A for insulating part. The releasable supporting plate 26, on which a plurality of the conductive path-forming parts 21 have been formed, is then superimposed on the releasable supporting plate 26, on which the material layer 22A for insulating part has been formed, as illustrated in Fig. 28, thereby bringing the electrodes 13 for current supply and electrodes 14 for voltage measurement in the connector 10 for measurement of electric resistance into contact with their corresponding conductive path-forming parts 21. Material layer 22A for insulating part is thereby formed between adjacent conductive path-forming parts 21. In this state, the material layer 22A for insulating part is then subjected to a curing treatment, whereby an insulating part 12 mutually insulating the adjacent conductive path-forming parts 21 is formed integrally with the conductive path-forming parts 11 and connector 10 for measurement of electric resistance between them as illustrated in Fig. 29.

The releasable supporting plate 26 is released, thereby obtaining an adaptor device of the construction shown in Fig. 20, in which the anisotropically conductive elastomer layer 20 is integrally formed on the front surface of the connector 10 for measurement of electric resistance.

In the above-described process, as means for applying the polymeric substance-forming material, may be used a printing method such as screen printing, roll coating method, blade coating method or the like.

The thickness of the material layer 22A for insulating part is preset according to the thickness of insulating part 22 to be formed.

The curing treatment of the material layer 22A for insulating part is generally conducted by a heating treatment. Specific heating temperature and heating time are suitably preset in view of the kind of the elastomer material forming the material layer 22A for insulating part, and the like.

According to the production process described above, the conductive elastomer layer 21A, in which the conductive particles P are dispersed in a state oriented so as to align in the thickness-wise direction, is subjected to the laser beam machining to remove a part thereof, thereby forming the conductive path-forming parts 21 of the intended form, so that an anisotropically conductive elastomer layer 20, in which conductive path-forming parts 21 charged with a necessary amount of the conductive particles P and having the expected conductivity have been formed, can be surely obtained.

Further, since a plurality of the conductive path-forming parts 21 arranged in accordance with the pattern of the electrodes 13 for current supply and electrodes 14 for voltage measurement are formed on the releasable supporting plate 26, and the material layer 22A for insulating part is then formed between these conductive path-forming parts 21 and subjected to the curing treatment, thereby forming the insulating part 22, an anisotropically conductive elastomer layer 20, in which an insulating part 22, in which the conductive particles P do not exist at all, has been formed, can be surely obtained.

In addition, it is unnecessary to use an expensive mold, in which a great number of ferromagnetic substance parts are arranged for forming the anisotropically conductive elastomer layer.

Since the forming step of the conductive path-forming parts 21 by the laser beam machining is conducted on the releasable supporting plate 26, the surface of the connector 10 for measurement of electric resistance is not damaged in the formation of the anisotropically conductive elastomer layer 20.

The connector devices for measurement of electric resistance of the present invention is not limited to the above-described embodiments, and various changes or modifications may be added thereto.

For example, the connector 10 for measurement of electric resistance may be any of the connector according to the second embodiment shown in Figs. 6 and 7 as illustrated in Fig. 30, the connector according to the third embodiment shown in Figs. 9 and 10, the connector according to the fourth embodiment shown in Fig. 11 and other connectors for measurement of electric resistance according to the present invention.

Further, the anisotropically conductive elastomer layer 20 may be such that a conductive path-forming part is formed so as to cover all the electrodes in the set of connecting electrodes, or may be that of the so-called dispersed type that the conductive particles are contained in an elastic polymeric substance in a state oriented so as to align in a thickness-wise direction thereof, and chains of the conductive particles are dispersed in a plane direction thereof.

### <Electric resistance-measuring apparatus for circuit board>

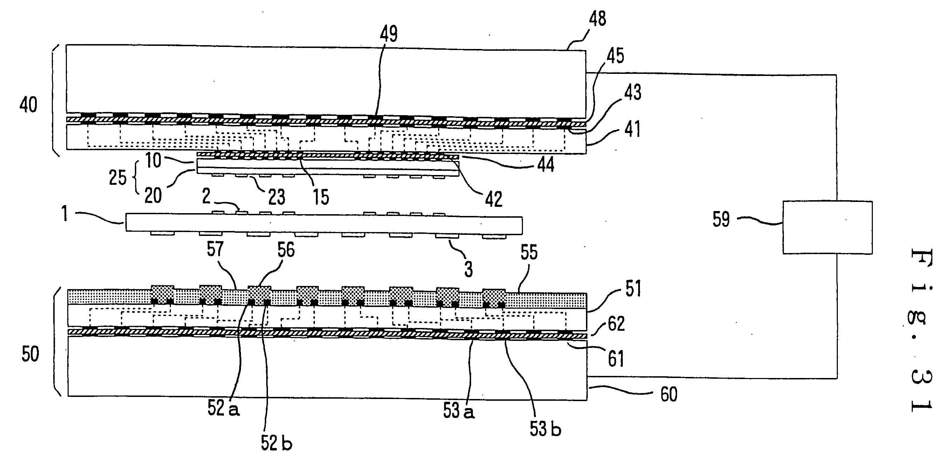

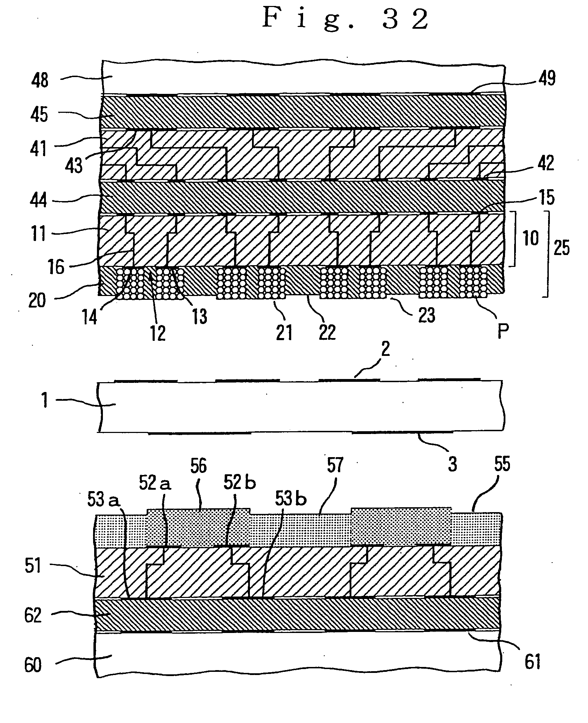

Fig. 31 illustrates the construction of an electric resistance-measuring apparatus for circuit boards according to a first embodiment of the present invention, and Fig. 32 illustrates, on an enlarged scale, a principal part of the electric resistance-measuring apparatus for circuit boards shown in Fig. 31.

The electric resistance-measuring apparatus for circuit boards according to the first embodiment is constructed by vertically arranging an upper-side adaptor 40 arranged on one surface (upper surface in Fig. 31) side of a circuit board 1 to be inspected, the electric resistance of which should be measured, and a lower-side adaptor 50 arranged on the other surface (lower surface in Fig. 31) side of the circuit board 1 to be inspected in opposed relation to each other.

In the upper-side adaptor 40, a connector device 25 for measurement of electric resistance of the construction shown in, for example, Fig. 12, which is arranged on one surface side (upper side in Fig. 31) of the circuit board 1 to be inspected, is provided. On the back surface (upper surface in Fig. 31) of the connector 10 for measurement of electric resistance in the connector device 25 for measurement of electric resistance, a one surface-side circuit board 41 for inspection is arranged through a first upper-side anisotropically conductive sheet 44. A plurality of inspection electrodes 42 are arranged on a front surface (lower surface in Fig. 31) of this one surface-side circuit board 41 for inspection according to a pattern corresponding to a pattern of relay electrodes 15 in the connector device 25 for measurement of electric resistance. On the back surface (upper surface in Fig. 31) of the one surface-side circuit board 41 for inspection, terminal electrodes 43 are arranged in accordance with a pattern corresponding to an arrangement pattern of standard arrangement electrodes 49 of an electrode plate 48, which will be described subsequently, and the respective terminal electrodes 43 are electrically connected to their corresponding inspection electrodes 42.

The electrode plate 48 is provided on the back surface of the one surface-side circuit board 41 for inspection through a second upper-side anisotropically conductive sheet 45. This electrode plate 48 has, on a front surface (lower surface in Fig. 31) thereof, a plurality of standard arrangement electrodes 49 arranged on standard lattice points having a pitch of, for example, 2.54 mm, 1.8 mm or 1.27 mm. These standard arrangement electrodes 49 are respectively electrically connected to the terminal electrodes 43 of the one surface-side circuit board 41 for inspection through the second upper-side anisotropically conductive sheet 45 and to a tester 59 through internal wiring (not illustrated) of the electrode plate 48.

The first upper-side anisotropically conductive sheet 44 in this embodiment is the so-called uneven distribution type anisotropically conductive sheet composed of a plurality of conductive path-forming parts (not illustrated) arranged in accordance with a pattern corresponding to the pattern of the relay electrodes 15 of the connector 10 for measurement of electric resistance and each extending in a thickness-wise direction, and an insulating part (not illustrated) intervening among these conductive path-forming parts to mutually insulate them. The conductive path-forming parts are formed by causing conductive particles to be contained in an insulating elastic polymeric substance in a state oriented so as to align in the thickness-wise direction. The insulating part is composed of an insulating elastic polymeric substance, which does not contain the conductive particles at all or scarcely contains them.

On the other hand, the second upper-side anisotropically conductive sheet 45 is the so-called dispersion type anisotropically conductive sheet that conductive particles are contained in an elastic polymeric substance in a state oriented so as to align in a thickness-wise direction of the sheet to form chains, and the chains of the conductive particles are dispersed in a plane direction of the sheet.

The elastic polymeric substances and conductive particles making up these first upper-side anisotropically conductive sheet 44 and second upper-side anisotropically conductive sheet 45 may be suitably selected and used from those exemplified as the elastic polymeric substances and conductive particles making up the anisotropically conductive elastomer layer 20 in the connector device 25 for measurement of electric resistance.

In the lower-side adaptor 50, an other surface-side circuit board 51 for inspection is provided, and pairs of inspection electrodes each composed of an inspection electrode 52a for current supply and an inspection electrode 52b for voltage measurement, which are arranged, in a state separated from each other, to one other surface-side electrode 3 to be inspected of the circuit board 1 to be inspected, are arranged on the front surface (upper surface in Fig. 31) of the other surface-side circuit board 51 for inspection in accordance with a pattern corresponding to an arrangement pattern of the other surface-side electrodes 3 to be inspected, so as to be located within a region of an area equivalent to the region occupied by the other surface-side electrode 3 to be inspected. Terminal electrodes 53a for current supply and terminal electrodes 53b for voltage measurement are arranged on the back surface of the other-side circuit board 51 for inspection according to a pattern corresponding to the arrangement pattern of standard arrangement electrodes 61 of an electrode plate 60, which will be described subsequently. These terminal electrodes 53a for current supply and terminal electrodes 53b for voltage measurement are electrically connected to their corresponding inspection electrodes 52a for current supply and inspection electrodes 52b for voltage measurement.

Anisotropically conductive elastomer layer 55 is integrally formed on the front surface of the other surface-side circuit board 51 for inspection. On the surface of this anisotropically conductive elastomer layer 55, are formed common conductive path-forming parts 56, which each come into contact with surfaces (upper surface in Fig. 31) of both inspection electrode 52a for current supply and inspection electrode 52b for voltage measurement making up each of the pairs of inspection electrodes. Insulating part 57 mutually insulating the conductive path-forming parts is formed between adjacent conductive path-forming parts 56. The conductive path-forming parts 56 are formed by causing conductive particles to be contained in an insulating elastic polymeric substance in a state oriented so as to align in a thickness-wise direction, and the insulating part 57 is composed of an insulating elastic polymeric substance which does not contain conductive particles at all or scarcely contains them. The anisotropically conductive elastomer layer 55 in this embodiment is formed in a state that surfaces (upper surfaces in Fig. 31) of the conductive path-forming parts 56 protrude from the surface of the insulating part 57.

The electrode plate 60 is provided on the back surface (lower surface in Fig. 31) of the other surface-side circuit board 51 for inspection through a lower-side anisotropically conductive sheet 62.

The electrode plate 60 and lower-side anisotropically conductive sheet 62 correspond to the electrode plate 48 and second upper-side anisotropically conductive sheet 45 in the upper-side adaptor 40, respectively. The electrode plate 60 has, on the surface (upper surface in Fig. 31) thereof, a plurality of the standard arrangement electrodes 61 arranged on standard lattice points having a pitch of, for example, 2.54 mm, 1.8 mm or 1.27 mm. Each of the standard arrangement electrodes 61 is electrically connected to the terminal electrode 53a for current supply or the terminal electrode 53b for voltage measurement of the other surface-side circuit board 51 for inspection through the lower-side anisotropically conductive sheet 62 and also to the tester 59 through internal wiring (not illustrated) of the electrode plate 60. The lower-side anisotropically conductive sheet 62 is the so-called dispersion type anisotropically conductive sheet that conductive particles are contained in an elastic polymeric substance in a state oriented so as to align in a thickness-wise direction to form chains, and the chains of the conductive particles are dispersed in a plane direction of the sheet.

The conductive path-forming parts 56 in the anisotropically conductive elastomer layer 55 preferably have higher conductivity in its thickness-wise direction than that in a plane direction perpendicular to the thickness-wise direction. Specifically, the conductive path-forming parts preferably have electrical properties that a ratio of the electric resistance value in the thickness-wise direction to the electric resistance value in the plane direction is 1 or lower, particularly 0.5 or lower.

If this ratio exceeds 1, a current flowing between the inspection electrode 52a for current supply and the inspection electrode 52b for voltage measurement through the conductive path-forming part 56 becomes high, so that it may be difficult in some cases to measure electric resistance with high precision.

From such a point of view, the filling rate of the conductive particles in the conductive path-forming parts 56 is preferably 5 to 50% by volume.

Such an anisotropically conductive elastomer layer 55 can be formed in accordance with any proper process, for example, a process described in Japanese Patent Application Laid-Open No. 2000-74965.

The elastic polymeric substances and conductive particles making up the anisotropically conductive elastomer layer 55 and lower-side anisotropically conductive sheet 62 may be suitably selected and used from those exemplified as the elastic polymeric substances and conductive particles making up the anisotropically conductive elastomer layer 20 in the connector device 25 for measurement of electric resistance.

A clearance between the inspection electrode 52a for current supply and the inspection electrode 52b for voltage measurement in the other surface-side circuit board 51 for inspection is preferably at least 10 µm. If this clearance is shorter than 10 µm, a current flowing between the inspection electrode 52a for current supply and the inspection electrode 52b for voltage measurement through the conductive paths-forming parts 56 becomes high, so that it may be difficult in some cases to measure electric resistance with high precision.

On the other hand, the upper limit of the clearance is determined by the size of the respective inspection electrodes and the dimensions and pitch of the other surface-side electrodes 3 to be inspected relating thereto, and is generally at most 500 µm. If this clearance is too long, it may be difficult in some cases to suitably arrange both inspection electrodes correspondingly to one of the other surface-side electrodes 3 to be inspected.

In the above-described electric resistance-measuring apparatus for circuit boards, an electric resistance between any one surface-side electrode 2 to be inspected and its corresponding other surface-side electrode 3 to be inspected in the circuit board 1 to be inspected is measured in the following manner.

The circuit board 1 to be inspected is arranged at a necessary position between the upper-side adaptor 40 and the lower-side adaptor 50, and in this state, the upper-side adaptor 40 is lowered, and the lower-side adaptor 50 is lifted, thereby bringing the anisotropically conductive elastomer layer 20 in the connector device 25 for measurement of electric resistance into contact under pressure with one surface of the circuit board 1 to be inspected and at the same time, bringing the anisotropically conductive elastomer layer 55 formed on the front surface of the other surface-side circuit board 51 for inspection into contact under pressure with the other surface of the circuit board 1 to be inspected. This state is a measurable state.

In this measurable state, a current of a constant value is supplied between the electrode 12 for current supply in the connector 10 for measurement of electric resistance and the inspection electrode 52a for current supply in the other surface-side circuit board 51 for inspection, one electrode 14 for voltage measurement among the electrodes 14 for voltage measurement electrically connected to the one surface-side electrodes 2 to be inspected is designated, a voltage between the designated one electrode 14 for volume measurement and an inspection electrode 52b for voltage measurement in a pair of inspection electrodes electrically connected to an other surface-side electrode 3 to be inspected corresponding to a one surface-side electrode 2 to be inspected electrically connected to the electrode 14 for voltage measurement is measured, and an electric resistance value between the one surface-side electrode 2 to be inspected electrically connected to the designated electrode 14 for voltage measurement and its corresponding other surface-side electrode 3 to be inspected is gained on the basis of the voltage value thus obtained.

Measurement of electric resistances between all the one surface-side electrodes 2 to be inspected and their corresponding other surface-side electrodes 3 to be inspected can be conducted by successively changing an electrode 14 for voltage measurement to be designated.

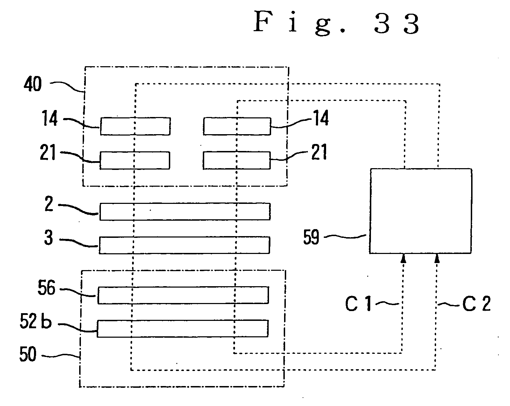

In the above-described process, when 2 electrodes 14 for voltage measurement in a set 12 of connecting electrodes of the connector 10 for measurement of electric resistance are electrically connected to a one surface-side electrode 2 to be inspected in the circuit board 1 to be inspected, 2 circuits C1 and C2 for voltage measurement are formed between the one surface-side electrode 2 to be inspected and its corresponding other surface-side electrode 3 to be inspected as shown in Fig. 33. In such a case, a higher value between an electric resistance value by the circuit C1 for voltage measurement and a voltage value by the circuit C2 for voltage measurement is adopted, and an electric resistance value between the one surface-side electrode 2 to be inspected and its corresponding other surface-side electrode 3 to be inspected is gained on the basis of this voltage value.

According to the electric resistance-measuring apparatus for circuit boards of the above-described construction, the connector 10 for measurement of electric resistance of the construction shown in Figs. 1 and 2 is provided on the upper-side adaptor 40 thereof, whereby tolerance for misregistration to the one surface-side electrodes 2 to be inspected in an electrically connecting operation to the circuit board 1 to be inspected is high, so that electrical connection of both electrode 13 for current supply and electrode 14 for voltage measurement to the one surface-side electrode 2 to be inspected can be surely achieved even when the circuit board 1 to be inspected is large in area and has a great number of small-sized one surface-side electrodes 2 to be inspected. In addition, since the electrode 13 for current supply and the electrode 14 for voltage measurement are electrically insulated from each other, the electric resistance as to the circuit board 1 to be inspected can be measured with high precision.

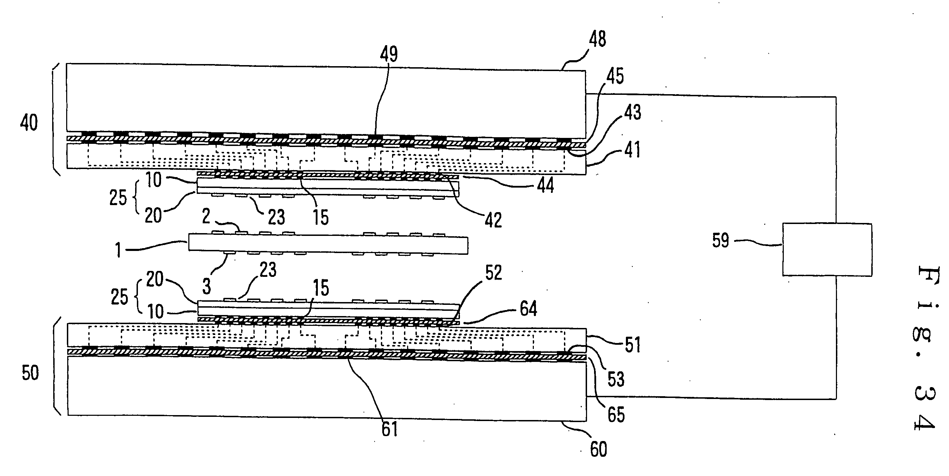

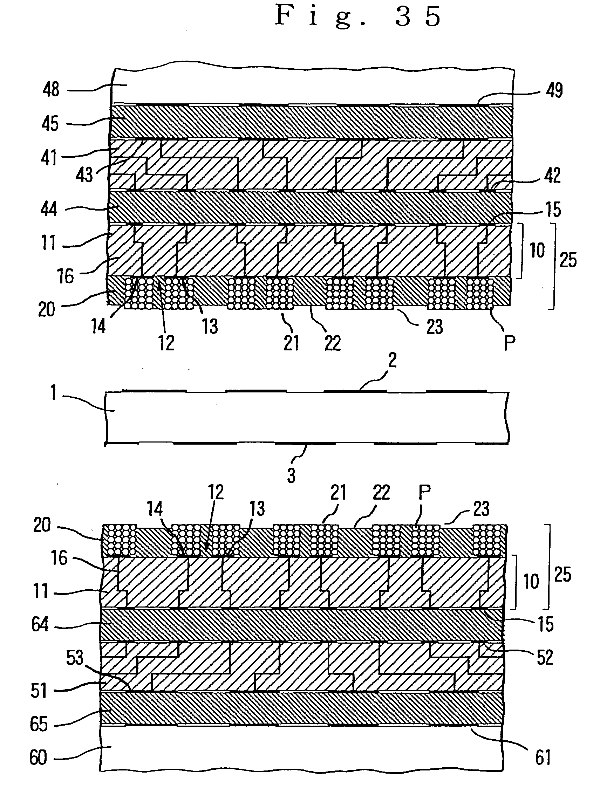

Fig. 34 illustrates the construction of an electric resistance-measuring apparatus for circuit boards according to a second embodiment of the present invention, and Fig. 35 illustrates, on an enlarged scale, a principal part of the electric resistance-measuring apparatus for circuit boards shown in Fig. 34.

The electric resistance-measuring apparatus for circuit boards according to the second embodiment is constructed by vertically arranging an upper-side adaptor 40 arranged on one surface (upper surface in Fig. 34) side of a circuit board 1 to be inspected, the electric resistance of which should be measured, and a lower-side adaptor 50 arranged on the other surface (lower surface in Fig. 34) side of the circuit board 1 to be inspected in opposed relation to each other. The upper-side adaptor 40 has the same construction as the upper-side adaptor in the electric resistance-measuring apparatus according to the first embodiment.

In the lower-side adaptor 50, a connector device 25 for measurement of electric resistance of the construction shown in, for example, Fig. 12, which is arranged on the other surface side (lower side in Fig. 34) of the circuit board 1 to be inspected, is provided. On the back surface (lower surface in Fig. 34) of the connector 10 for measurement of electric resistance in the connector device 25 for measurement of electric resistance, an other surface-side circuit board 51 for inspection is arranged through a first lower-side anisotropically conductive sheet 64. An electrode plate 60 is provided on a back surface of the other surface-side circuit board 51 for inspection through a second lower-side anisotropically conductive sheet 65. This electrode plate 60 has the same construction as the electrode plate in the lower-side adaptor of the electric resistance-measuring apparatus according to the first embodiment.

A plurality of inspection electrodes 52 are arranged on a front surface (upper surface in Fig. 34) of the other surface-side circuit board 51 for inspection according to a pattern corresponding to a pattern of relay electrodes 15 in the connector device 25 for measurement of electric resistance. On the back surface (lower surface in Fig. 34) of the other surface-side circuit board 51 for inspection, terminal electrodes 53 are arranged in accordance with a pattern corresponding to an arrangement pattern of standard arrangement electrodes 61 of the electrode plate 60, and the respective terminal electrodes 53 are electrically connected to their corresponding inspection electrodes 52.

The first lower-side anisotropically conductive sheet 64 in this embodiment is the so-called uneven distribution type anisotropically conductive sheet composed of a plurality of conductive path-forming parts (not illustrated) arranged in accordance with a pattern corresponding to the pattern of the relay electrodes 15 of the connector 10 for measurement of electric resistance and each extending in a thickness-wise direction, and an insulating part (not illustrated) intervening among these conductive path-forming parts to mutually insulate them. The conductive path-forming parts are formed by causing conductive particles to be contained in an insulating elastic polymeric substance in a state oriented so as to align in the thickness-wise direction. The insulating part is composed of an insulating elastic polymeric substance, which does not contain the conductive particles at all or scarcely contains them.

On the other hand, the second lower-side anisotropically conductive sheet 65 is the so-called dispersion type anisotropically conductive sheet that conductive particles are contained in an elastic polymeric substance in a state oriented so as to align in a thickness-wise direction to form chains, and the chains of the conductive particles are dispersed in a plane direction of the sheet.

The elastic polymeric substances and conductive particles making up these first lower-side anisotropically conductive sheet 64 and second lower-side anisotropically conductive sheet 65 may be suitably selected and used from those exemplified as the elastic polymeric substances and conductive particles making up the anisotropically conductive elastomer layer 20 in the connector device 25 for measurement of electric resistance.

In the above-described electric resistance-measuring apparatus for circuit boards, an electric resistance between any one surface-side electrode 2 to be inspected and its corresponding other surface-side electrode 3 to be inspected in the circuit board 1 to be inspected is measured in the following manner.

The circuit board 1 to be inspected is arranged at a necessary position between the upper-side adaptor 40 and the lower-side adaptor 50, and in this state, the upper-side adaptor 40 is lowered, and the lower-side adaptor 50 is lifted, thereby bringing the anisotropically conductive elastomer layer 20 in the connector device 25 for measurement of electric resistance in the upper-side adaptor 40 into contact under pressure with one surface of the circuit board 1 to be inspected and at the same time, bringing the anisotropically conductive elastomer layer 20 in the connector device 25 for measurement of electric resistance in the lower-side adaptor 50 into contact under pressure with the other surface of the circuit board 1 to be inspected. This state is a measurable state.

In this measurable state, a current of a constant value is supplied between the electrode 12 for current supply in the connector 10 for measurement of electric resistance of the upper-side adaptor 40 and the electrode 12 for current supply in the connector 10 for measurement of electric resistance of the lower-side adaptor 50, one electrode 14 for voltage measurement among the electrodes 14 for voltage measurement electrically connected to the one surface-side electrodes to be inspected is designated, a voltage between the designated one electrode 14 for volume measurement and an electrode 14 for voltage measurement electrically connected to an other surface-side electrode 3 to be inspected corresponding to the one surface-side electrode 2 to be inspected electrically connected to the designated electrode 14 for voltage measurement is measured, and an electric resistance value between the one surface-side electrode 2 to be inspected electrically connected to the designated electrode 14 for voltage measurement and its corresponding other surface-side electrode 3 to be inspected is gained on the basis of the voltage value thus obtained.

Measurement of electric resistances between all the one surface-side electrodes 2 to be inspected and their corresponding other surface-side electrodes 3 to be inspected can be conducted by successively changing an electrode 14 for voltage measurement to be designated.

In the above-described process, when 2 electrodes 14 for voltage measurement in a set 12 of connecting electrodes of the connector 10 for measurement of electric resistance are electrically connected to a one surface-side electrode 2 to be inspected in the circuit board 1 to be inspected, and 2 electrodes 14 for voltage measurement in a set 12 of connecting electrodes of the connector 10 for measurement of electric resistance are electrically connected to an other surface-side electrode 3 to be inspected in the circuit board 1 to be inspected, 4 circuits C1, C2, C3 and C4 for voltage measurement are formed between the one surface-side electrode 2 to be inspected and its corresponding other surface-side electrode 3 to be inspected. In such a case, a highest value among voltage values of each of the circuit C1 for voltage measurement, the circuit C2 for voltage measurement, the circuit C3 for voltage measurement and the circuit C4 for voltage measurement is adopted, and an electric resistance value between the one surface-side electrode 2 to be inspected and its corresponding other surface-side electrode 3 to be inspected is gained on the basis of this voltage value.

According to the electric resistance-measuring apparatus for circuit boards of the above-described construction, the connector 10 for measurement of electric resistance of the construction shown in Figs. 1 and 2 is provided on both upper-side adaptor 40 and lower-side adaptor 50, whereby tolerance for misregistration to the one surface-side electrodes 2 to be inspected and the other surface-side electrodes 3 to be inspected in an electrically connecting operation to the circuit board 1 to be inspected is high, so that electrical connection of both electrode 13 for current supply and electrode 14 for voltage measurement to the one surface-side electrode 2 to be inspected and the other surface-side electrode 3 to be inspected can be surely achieved even when the circuit board 1 to be inspected is large in area and has a great number of small-sized one surface-side electrodes 2 to be inspected and other surface-side electrodes 3 to be inspected. In addition, since the electrode 13 for current supply and the electrode 14 for voltage measurement are electrically insulated from each other, the electric resistance as to the circuit board 1 to be inspected can be measured with high precision.

The electric resistance-measuring apparatus according to the present invention are not limited to the above-described embodiments, and such various changes or modifications as described below may be added thereto.

For example, in the first embodiment, as the other surface-side circuit board 51 for inspection of the lower-side adapter 50, various types may be used so far as a state that the inspection electrode 52 for current supply and inspection electrode 53 for voltage measurement making up a pair of inspection electrodes have been electrically connected to an other surface-side electrode 3 to be inspected can be achieved.

Further, as the anisotropically conductive elastomer layer 55, may be used that conductive path-forming parts are formed corresponding to each of the inspection electrodes 52 for current supply and inspection electrodes 53 for voltage measurement.

Inspection electrodes, on the each tip of which a conductive elastomer is provided, and further probe pins, if permitted, may also be used as inspection electrodes.

When the circuit board to be inspected is a single-sided printed circuit board, there is no need to provide the lower-side adaptor.

The present invention will hereinafter be described specifically by the following Examples. However, the present invention is not limited to the following Examples.

In the following Examples, a single-sided printed circuit board of the following specification was used as a circuit board to be inspected.

A single-sided printed circuit board having dimensions of 3 cm by 3 cm, in which 4 electrode groups in total each composed of 600 electrodes to be inspected having a diameter of 100 µm and arranged at a pitch of 0.2 mm are formed on one surface thereof (the total number of electrodes to be inspected: 2,400), and every 2 electrodes among the 600 electrodes to be inspected in each electrode group are electrically connected to each other through internal wiring to form a circuit (the number of circuits in each electrode group: 300; the total number of circuits: 1,200).

### <Example 1>

### {Connector for measurement of electric resistance}

A connector for measurement of electric resistance of the following specification was produced in accordance with the construction shown in Figs. 1 and 2.

### Insulating substrate (11):

Material: glass fiber-reinforced epoxy resin,
Dimensions of insulating substrate (11): 100 mm x 100 mm x 0.5 mm.

### Set (12) of connecting electrodes:

Dimensions of electrode for current supply (13) and electrode for voltage measurement (14): 50 µm x 50 µm,
Clearance between electrode for current supply (13) and electrode for voltage measurement (14): 30 µm,
Pitch of set (12) of connecting electrodes: 200 µm,
The number of sets (12) of connecting electrodes: 600.

### Relay electrode (15):

Dimensions of relay electrode (15): 120 µm in diameter (circle)
Pitch of relay electrode (15) : 350 µm,
The number of relay electrodes (15) : 1,200

### [Connector device for measurement of electric resistance]

An anisotropically conductive elastomer layer was formed on a front surface of the above-described connector for measurement of electric resistance in the following manner to produce a connector device for measurement of electric resistance.

### (1) Mold:

A mold for obtaining the anisotropically conductive elastomer layer was produced in accordance with the construction shown in Fig. 14 and the following specification.

More specifically, a material of respective ferromagnetic base plates (31, 36) in a top force (30) and a bottom force (35) is iron, and the thickness thereof is 10 mm. A material of ferromagnetic substance layers (32, 37) is nickel, the planar form of each layer is circular, and dimensions thereof are 300 µm in diameter and 100 µm in thickness. A material of a non-magnetic substance layer (33) in the top force (30) is a dry film resist subjected to a curing treatment, and a thickness thereof is 150 µm. A material of a non-magnetic substance layer (38) in the bottom force (35) is a dry film resist subjected to a curing treatment, and a thickness thereof is 100 µm.

### (2) Material for elastomer:

After 15 parts by weight of conductive particles having an average particle diameter of 10 µm were added into 100 parts by weight of addition type liquid silicone rubber, the resultant mixture was subjected to a defoaming treatment by pressure reduction, thereby preparing a material for elastomer. In the above-described process, those (average coating amount: 4% by weight of the weight of core particles) obtained by plating core particles composed of nickel with gold were used as the conductive particles. The viscosity of the material for elastomer was 4,800 P at a temperature of 25°C.

### (3) Anisotropically conductive elastomer layer:

The material for elastomer thus prepared was applied to a front surface of the connector (10) for measurement of electric resistance by screen printing, thereby forming a material layer (20A) for elastomer, and the top force (30) and the bottom force (35) were arranged on a front surface of this material layer (20A) for elastomer and a back surface of the connector 10 for measurement of electric resistance, respectively. Thereafter, the material layer (20A) for elastomer was subjected to a curing treatment under conditions of 125°C and 2 hours while applying a magnetic field of 2 T to portions located between the ferromagnetic substance layers (32) of the top force (30) and the ferromagnetic substance layers (37) of the bottom force (35) of the material layer (20A) for elastomer in a thickness-wise direction thereof by arranging electromagnets on a lower surface of the top force (30) and a lower surface of the bottom force (35), respectively, and operating the electromagnets, thereby forming, on the front surface of the connector (10) for measurement of electric resistance, an elastomer layer (20B) containing the conductive particles exhibiting magnetism in a state oriented so as to align in the thickness-wise direction at the portions located on the surfaces of the connecting electrode set regions.

The elastomer layer (20B) thus obtained was subjected to laser beam machining by carbon dioxide gas laser, thereby removing portions located on the surfaces of regions between the respective electrodes of the sets (12) of connecting electrodes in the portions containing the conductive particles to form hole portions (K) of a cross form. Addition type liquid silicone rubber was then filled into the hole portions (K), and the addition type liquid silicone rubber was subjected to a curing treatment under conditions of 125°C and 2 hours, thereby forming an anisotropically conductive elastomer layer (20), thus producing a connector device (25) for measurement of electric resistance.

### (4) Electric resistance-measuring apparatus for circuit board:

The above-described connector device for measurement of electric resistance was used to produce an electric resistance-measuring apparatus shown in Fig. 31 comprising an upper-side adaptor and a tester.

### <Comparative Example 1>

An electric resistance-measuring apparatus having a circuit board for inspection, on the front surface of which electrodes for current supply and electrodes for voltage measurement were formed corresponding to electrodes to be inspected, a connecting member composed of a conductive elastomer provided on a front surface of the circuit board for inspection, and a holding member was produced in accordance with the construction described in Japanese Patent Application Laid-Open No. 2000-74965.

In the circuit board for inspection, the electrodes for current supply and electrodes for voltage measurement each had dimensions of 120 µm long and 40 µm wide. A clearance between the electrode for current supply and the electrode for voltage measurement was 40 µm, the thickness of the connecting member was 0.06 mm, silicone rubber was used as an elastic polymeric substance for forming the connecting member, and nickel particles plated with gold, which had an average particle diameter of 10 µm, were used as conductive particles.

### [Evaluation]

A total of 200 circuit boards to be inspected of the above-described specification were provided, and an electric resistance of each circuit in these circuit boards to be inspected was measured by means of the electric resistance-measuring apparatus according to Example 1 and Comparative Example 1 to make a judgment as the connection fault when the measured value of the electric resistance in the circuit was 1 Ω or higher, thereby counting the number thereof.

As a result, the number of circuit boards having a circuit, the measured value of electric resistance of which was 1 Ω or higher was 0 among 100 circuit boards (1,200 circuits x 100) in the electric resistance-measuring apparatus according to Example 1, while the number of circuit boards having a circuit, the measured value of electric resistance of which was 1 Ω or higher was 25 among 100 circuit boards (1,200 circuits x 100) in the electric resistance-measuring apparatus according to Comparative Example 1.

## Claims

1. A connector for measurement of electric resistance, comprising an insulating substrate and plural sets of connecting electrodes arranged on a front surface of the insulating substrate in accordance with a pattern corresponding to a pattern of a plurality of electrodes to be inspected in a circuit board to be inspected, the electric resistance of which should be measured,
wherein each of the sets of connecting electrodes is composed of at least 3 electrodes of electrode(s) for current supply and electrode(s) for voltage measurement arranged in a state separated from one another, at least one of these electrodes is an electrode for current supply, and at least one thereof is an electrode for voltage measurement.

2. A connector for measurement of electric resistance, comprising an insulating substrate and plural sets of connecting electrodes arranged on a front surface of the insulating substrate in accordance with a pattern corresponding to a pattern of a plurality of electrodes to be inspected in a circuit board to be inspected, the electric resistance of which should be measured,
wherein each of the sets of connecting electrodes is composed of 2 electrodes for current supply, which are located at vertical positions of angles opposite to each other in a rectangle, and 2 electrodes for voltage measurement, which are located at the other vertical positions of angles opposite to each other, said electrodes being arranged in a state separated from one another.

3. A connector for measurement of electric resistance, comprising an insulating substrate and plural sets of connecting electrodes arranged on a front surface of the insulating substrate in accordance with a pattern corresponding to a pattern of a plurality of electrodes to be inspected in a circuit board to be inspected, the electric resistance of which should be measured,
wherein each of the sets of connecting electrodes is composed of 3 electrodes of an electrode for voltage measurement, an electrode for current supply and an electrode for voltage measurement, which are arranged in a state separated from one another so as to align in this order.

4. A connector for measurement of electric resistance, comprising an insulating substrate and plural sets of connecting electrodes arranged on a front surface of the insulating substrate in accordance with a pattern corresponding to a pattern of a plurality of electrodes to be inspected in a circuit board to be inspected, the electric resistance of which should be measured,
wherein each of the sets of connecting electrodes is composed of 3 electrodes of an electrode for current supply, an electrode for voltage measurement and an electrode for current supply, which are arranged in a state separated from one another so as to align in this order.

5. The connector for measurement of electric resistance according to claim 3 or 4, wherein each of the electrodes for current supply and the electrodes for voltage measurement in the set of connecting electrode has a form long in a direction perpendicular to the arrangement direction of these electrodes.

6. The connector for measurement of electric resistance according to any one of claims 1 to 5, wherein a plurality of relay electrodes electrically connected to any ones of the electrodes for current supply and electrodes for voltage measurement are arranged on a back surface of the insulating substrate.

7. The connector for measurement of electric resistance according to claim 6, which has relay electrodes electrically connected to a plurality of the electrodes for current supply.

8. A connector device for measurement of electric resistance, comprising the connector for measurement of electric resistance according to any one of claims 1 to 7, and an anisotropically conductive elastomer layer integrally laminated on a front surface of the connector for measurement of electric resistance.

9. The connector device for measurement of electric resistance according to claim 8, wherein the anisotropically conductive elastomer layer is composed of a plurality of conductive path-forming parts arranged on the respective surfaces of the electrodes for current supply and the electrodes for voltage measurement and each extending in a thickness-wise direction thereof, and an insulating part mutually insulating these conductive path-forming parts.

10. The connector device for measurement of electric resistance according to claim 9, wherein the conductive path-forming parts in the anisotropically conductive elastomer layer contain conductive particles exhibiting magnetism in a state oriented so as to align in the thickness-wise direction.

11. A process for producing the connector device for measurement of electric resistance according to claim 10, which comprises the steps of
forming, on a front surface of the connector for measurement of electric resistance according to any one of claims 1 to 7, an elastomer layer containing conductive particles exhibiting magnetism in portions located on the surfaces of the regions, in which the sets of connecting electrodes of the connector for measurement of electric resistance have been formed, in a state oriented so as to align in a thickness-wise direction thereof by forming, on the front surface of the connector for measurement of electric resistance, a material layer for elastomer with the conductive particles exhibiting magnetism contained in a liquid polymeric substance-forming material, which will become an elastic polymeric substance by being cured, applying a magnetic field having higher intensity at portions located on the surfaces of the regions, in which the sets of connecting electrodes have been formed, than the other portions, to the material layer for elastomer in a thickness-wise direction thereof and subjecting the material layer for elastomer to a curing treatment,
removing portions located on the surfaces of regions between the respective electrodes of the sets of connecting electrodes in the portions containing the conductive particles in this elastomer layer to form hole portions, and then
filling a liquid polymeric substance-forming material, which will become an elastic polymeric substance by being cured, into the hole portions and subjecting the polymeric substance-forming material to a curing treatment.

12. An electric resistance-measuring apparatus for circuit boards for measuring an electric resistance of a circuit board having electrodes on at least one surface thereof, which comprises
the connector for measurement of electric resistance according to any one of claims 1 to 7, which is arranged on one surface side of a circuit board to be inspected, the electric resistance of which should be measured.

13. An electric resistance-measuring apparatus for circuit boards for measuring an electric resistance of a circuit board having electrodes on at least one surface thereof, which comprises
the connector for measurement of electric resistance according to claim 6 or 7, which is arranged on one surface side of a circuit board to be inspected, the electric resistance of which should be measured, and
a one surface-side circuit board for inspection arranged on a back surface of this connector for measurement of electric resistance through an anisotropically conductive sheet and having, on its surface, inspection electrodes arranged in accordance with a pattern corresponding to a pattern of the relay electrodes in the connector for measurement of electric resistance.

14. The electric resistance-measuring apparatus for circuit boards according to claim 12 or 13, which is an electric resistance-measuring apparatus for circuit boards for measuring an electric resistance of a circuit board having electrodes on both surfaces thereof, and further comprises an other surface-side circuit board for inspection arranged on the other surface side of the circuit board to be inspected, the electric resistance of which should be measured,
wherein the other surface-side circuit board for inspection has, on its front surface, an electrode for current supply and an electrode for voltage measurement, which are arranged corresponding to each of the other surface-side electrodes to be inspected of the circuit board to be inspected and in a state separated from each other, and formed electrically connected to the same other surface-side electrode to be inspected.

15. An electric resistance-measuring apparatus for circuit boards for measuring an electric resistance of a circuit board having electrodes on both surfaces thereof, which comprises
the connector for measurement of electric resistance according to any one of claims 1 to 7, which is arranged on one surface side of a circuit board to be inspected, the electric resistance of which should be measured, and
the connector for measurement of electric resistance according to any one of claims 1 to 7, which is arranged on the other surface side of the circuit board to be inspected.

16. An electric resistance-measuring apparatus for circuit boards for measuring an electric resistance of a circuit board having electrodes on both surfaces thereof, which comprises
the connector for measurement of electric resistance according to claim 6 or 7, which is arranged on one surface side of a circuit board to be inspected, the electric resistance of which should be measured,
a one surface-side circuit board for inspection arranged on a back surface of this connector for measurement of electric resistance through an anisotropically conductive sheet and having, on its surface, inspection electrodes arranged in accordance with a pattern corresponding to a pattern of the relay electrodes of the connector for measurement of electric resistance,
the connector for measurement of electric resistance according to claim 6 or 7, which is arranged on the other surface side of the circuit board to be inspected, and
an other surface-side circuit board for inspection arranged on a back surface of this connector for measurement of electric resistance through an anisotropically conductive sheet and having, on its surface; inspection electrodes arranged in accordance with a pattern corresponding to a pattern of the relay electrodes of the connector for measurement of electric resistance.

17. An electric resistance-measuring method for circuit boards, which comprises arranging the connector for measurement of electric resistance according to any one of claims 1 to 7 on one surface of a circuit board to be inspected, the electric resistance of which should be measured,
electrically connecting at least one electrode for current supply and at least one electrode for voltage measurement in the set of connecting electrodes of the connector for measurement of electric resistance at the same time to each of one surface-side electrodes to be inspected of the circuit board to be inspected, thereby bringing about a measurable state, and
in this measurable state, supplying a current to the circuit board to be inspected through the electrode for current supply in the connector for measurement of electric resistance and designating one electrode for voltage measurement among the electrodes for voltage measurement electrically connected to the one surface-side electrodes to be inspected to perform measurement of an electric resistance as to the one surface-side electrode to be inspected electrically connected to the designated one electrode for voltage measurement.
